# EUROPEAN PATENT SPECIFICATION

(11) **EP 1 673 201 B1**
(45) Date of publication and mention of the grant of the patent: **02.07.2014**
(21) Application number: 04792716.5
(22) Date of filing: 14.10.2004
(51) Int. Cl.: B24B 37/04, B24B 37/34

(54) **POLISHING APPARATUS AND METHOD**
POLIERVORRICHTUNG UND POLIERVERFAHREN
APPAREIL ET PROCEDE DE POLISSAGE

(30) Priority: 17.10.2003 JP 2003358593
(43) Date of publication of application: 28.06.2006
(73) Proprietor: EBARA CORPORATION, Ohta-ku, Tokyo 144-8510 (JP)
(72) Inventor: TORII, Hiroomi, c/o Ebara Corporation, Tokyo 144-8510 (JP); HAYAMA, Takuji, c/o Ebara Corporation, Tokyo 144-8510 (JP); YASHIMA, Tetsuya, c/o Ebara Corporation, Tokyo 144-8510 (JP)
(74) Representative: Emde, Eric
(86) International application number: PCT/JP2004/015566
(87) International publication number: WO 2005/037488

(56) References cited:
- EP-A- 0 774 323
- EP-A- 1 034 887
- WO-A-99/41022
- US-A1- 2001 055 937
- PATENT ABSTRACTS OF JAPAN vol. 1997, no. 01, 31 January 1997 (1997-01-31) -& JP 08 229807 A (FUJIKOSHI MACH CORP), 10 September 1996 (1996-09-10)

## Description

### Technical Field

The present invention relates to a polishing apparatus for polishing a substrate such as a semiconductor wafer to a flat mirror finish, and more particularly to a polishing apparatus having a substrate relay device for transferring a substrate between a substrate holding device such as a top ring or a carrier head and a transfer device such a robot or a transporter.

### Background Art

In recent years, semiconductor devices have become more integrated, and structures of semiconductor elements have become more complicated. Further, the number of layers in multilayer interconnects used for a logical system has been increased. Accordingly, irregularities on a surface of a semiconductor device are increased, so that step heights on the surface of the semiconductor device tend to be large. This is because, in a manufacturing process of a semiconductor device, a thin film is formed on a semiconductor device, then micromachining processes, such as patterning or forming holes, are performed on the semiconductor device, and these processes are repeated to form subsequent thin films on the semiconductor device.

When the number of irregularities is increased on a surface of a semiconductor device, the following problems arise. When a thin film is formed on a semiconductor device, the thickness of the film formed at portions having a step is relatively small. Further, an open circuit may be caused by disconnection of interconnects, or a short circuit may be caused by insufficient insulation between interconnect layers. As a result, good products cannot be obtained, and the yield tends to be lowered. Further, even if a semiconductor device initially works normally, reliability of the semiconductor device is lowered after a long-term use. At the time of exposure in a lithography process, if the irradiation surface has irregularities, then a lens unit in an exposure system is locally unfocused. Therefore, if the irregularities of the surface of the semiconductor device are increased, then it becomes problematically difficult to form a fine pattern itself on the semiconductor device.

Thus, in a manufacturing process of a semiconductor device, it becomes increasingly important to planarize a surface of the semiconductor device. The most important one of the planarizing technologies is chemical mechanical polishing (CMP). In a polishing apparatus for chemical mechanical polishing, while a polishing liquid containing abrasive particles such as silica (SiO₂) therein is supplied onto a polishing surface such as a polishing pad, a substrate such as a semiconductor wafer is brought into sliding contact with the polishing surface, so that the substrate is polished.

This type of polishing apparatus includes a polishing table having a polishing surface formed by a polishing pad, and a substrate holding device, which is referred to as a top ring or a carrier head, for holding a substrate such as a semiconductor wafer. When a semiconductor wafer is polished with such a polishing apparatus, the semiconductor wafer is held and pressed against the polishing table under a predetermined pressure by the substrate holding device. At that time, the polishing table and the substrate holding device are moved relative to each other to bring the semiconductor wafer into sliding contact with the polishing surface, so that the surface of the semiconductor wafer is polished to a flat mirror finish.

In such a polishing apparatus, if a relative pressing force between the semiconductor wafer being polished and the polishing surface of the polishing pad is not uniform over an entire surface of the semiconductor wafer, then the semiconductor wafer may insufficiently be polished or may excessively be polished at some portions depending on the pressing force applied to those portions of the semiconductor wafer. Therefore, it has been attempted to form a surface, for holding a semiconductor wafer, of a substrate holding device by a membrane made of an elastic material such as rubber and to supply fluid pressure such as air pressure to a backside surface of the membrane to uniformize pressing forces applied to the semiconductor wafer over an entire surface of the semiconductor wafer.

If a transfer device such as a robot is used to directly deliver a semiconductor wafer to be polished to the substrate holding device and directly receive a polished semiconductor wafer from the substrate holding device, then the transfer device may fail the transfer because of a difference of transferring precision between the transfer device and the substrate holding device. Accordingly, the polishing apparatus may include a substrate relay device disposed at a delivery position of a semiconductor wafer to the substrate holding device or at a receiving position of a semiconductor wafer from the substrate holding device. Such a substrate relay device is referred to as a pusher. A semiconductor wafer transferred by a transfer device such as a robot is placed on the substrate relay device. Then, the substrate relay device lifts the semiconductor wafer to the substrate holding device such as a top ring, which has been moved above the substrate relay device, and delivers the semiconductor wafer to the substrate holding device. Further, the substrate relay device receives the semiconductor wafer from the substrate holding device and delivers the semiconductor wafer to the transfer device.

When a substrate such as a semiconductor wafer is transferred from a substrate holding device such as a top ring to a pusher (substrate relay device), a pressurized fluid (a gas, a liquid, or a mixture of a gas and a liquid) is introduced into a fluid passage provided in the top ring to eject and remove the semiconductor wafer from the top ring. At that time, since a gap is formed between the top ring and the pusher, the semiconductor wafer falls down through the gap after it is separated from the top ring. The pusher catches and receives the fallen semiconductor wafer.

In the aforementioned polishing apparatus, a semiconductor wafer is polished under various polishing conditions including the type of slurry (polishing liquid), polishing time, pressing forces of the semiconductor wafer, and rotational speeds of a top ring and a polishing table. Under some polishing conditions, a polished semiconductor wafer may firmly adhere to the top ring when the semiconductor wafer is to be separated from the top ring. In such a case, the semiconductor wafer cannot be removed from the top ring. Particularly, when a surface, for holding a semiconductor wafer, of a substrate holding device is formed by a membrane, and a fluid pressure such as air pressure is supplied to a backside surface of the membrane to press the semiconductor wafer against the polishing surface on the polishing table, the following problems may arise because the membrane is made of rubber. When the semiconductor wafer is to be separated

from the substrate holding device after polishing, the semiconductor wafer adheres to the membrane so that it cannot be removed from the substrate holding device. Otherwise, it takes much time to separate the semiconductor wafer from the substrate holding device. Further, the semiconductor wafer may fall down in an oblique state while a portion of the semiconductor wafer adheres to the membrane. In such cases, if a pressure of the fluid ejected from the top ring is increased in order to reliably remove the semiconductor wafer from the top ring, then the semiconductor wafer falls down toward the pusher with force, thereby causing damage or breakage of the semiconductor wafer.

In recent years, low-k materials having a low dielectric constant have been developed as interlayer dielectrics instead of Si0₂. However, such low-k materials have a low mechanical strength and are thus likely to be broken. Accordingly, if a semiconductor wafer employing such a low-k material is to be removed from the top ring by ejection of a pressurized fluid, the low-k material in the semiconductor wafer is broken by impact of falling, so that the yield is lowered. Attention is drawn to EP 0 774 323 A, which shows a polishing apparatus and a method for polishing a substrate in accordance with the preamble of claims 1 and 3, respectively.

### Disclosure of Invention

In accordance with the present invention, an apparatus and a method as set forth in claims 1 and 3 is provided. Further embodiments of the invention are claimed in the dependent claims.

The present invention has been made in view of the above drawbacks. It is therefore an object of the present invention to provide a polishing apparatus which can quickly and reliably separate a substrate such as a semiconductor wafer from a substrate holding device such as a top ring after polishing, can safely remove the substrate from the substrate holding device without an excessive force being- applied to the substrate, and can have no impact upon the substrate when the substrate is transferred from the substrate holding device to a substrate relay device.

When a substrate is transferred from the substrate holding device to the substrate relay device, a high-pressure fluid is ejected from the high-pressure fluid port between the substrate holding surface of the substrate holding device and the substrate. Thus, the substrate can be removed from the substrate holding device by pressure of the high-pressure fluid.

The high-pressure fluid port may be configured to eject the high-pressure fluid between the substrate holding surface of the substrate holding device and the substrate to separate the substrate from the said substrate holding surface of the substrate holding device. The substrate relay device may include a cover provided around the high-pressure fluid port to prevent the high-pressure fluid from scattering around the high-pressure fluid port.

When a substrate is transferred from the substrate holding device to the substrate relay device, the substrate is attracted by a fluid film (liquid film), which is formed on the substrate placement surface of the substrate placement section of the substrate relay device. Therefore, the substrate can reliably be removed from the substrate holding device by surface tension of the fluid film. Further, since the substrate is attracted by the fluid film, it is possible to prevent the substrate from falling down toward the substrate relay device with force due to ejection of a pressurized fluid when the substrate is released from the substrate holding device. Thus, the substrate is subjected to no impact.

The fluid supply passage may be configured to form the fluid film on the substrate placement surface of the substrate placement section so that the substrate is attracted to the substrate placement surface by the fluid film when the substrate is transferred between the substrate holding device and the substrate relay device. The fluid supply passage may be configured to supply the fluid onto the substrate placement surface of the substrate placement section to separate the substrate from the substrate placement surface after the substrate has been transferred from the substrate holding device to the substrate relay device.

When a substrate is transferred from the substrate holding device to the substrate relay device, the substrate is attracted to the attraction section of the substrate relay device. Therefore, the substrate can reliably be removed from the substrate holding device. Further, since the attraction section attracts the substrate, it is possible to prevent the substrate from falling down toward the substrate relay device with force due to ejection of a pressurized fluid when the substrate is released from the substrate holding device. Thus, the substrate is subjected to no impact.

The attraction section may include an attraction section body having a chamber surface. The fluid chamber may be defined by the chamber surface of the attraction section body and the elastic body. The attraction section body may have a recessed surface as the chamber surface. The attraction section may be operable to attract the substrate by evacuating the fluid chamber through the passage when the substrate is transferred between the substrate holding device and the substrate relay device. The attraction section may be operable to separate the substrate from the attraction section by supplying a fluid from the fluid supply source through the passage after the substrate has been transferred from the substrate holding device to the substrate relay device.

The chucking mechanism may include a link configured to be introduced between the substrate holding surface of the substrate holding device and the substrate. Alternatively, the chucking mechanism may include a link configured to hold a peripheral edge of the substrate.

When a substrate is transferred from the substrate holding device to the substrate relay device, a tip of the chucking mechanism is introduced between the substrate holding surface of the substrate holding device and the substrate, or a peripheral edge of the substrate is held by the chucking mechanism. Thus, the substrate can forcibly be separated from the substrate holding surface by the chucking mechanism.

Thus, the substrate placement section and the substrate are immersed in a liquid stored in the tub. The liquid is introduced between the substrate and the substrate holding surface of the substrate holding device to release adherence of the substrate to the substrate holding device. Accordingly, the substrate can be separated from the substrate holding device. Further, since the liquid is present between the substrate placement section and the substrate when the substrate is separated from the substrate holding device, it is possible to prevent the substrate from falling down toward the substrate relay device with force due to ejection of a pressurized fluid.

The substrate holding device may have a passage configured to supply a pressurized fluid from the substrate holding surface to the substrate when the substrate is transferred from the substrate holding device to the substrate relay device. The substrate holding device may include an elastic pad having the substrate holding surface. The elastic pad may include an opening connected to a fluid supply source and/or a vacuum source. The substrate holding device may include a support member configured to support the elastic pad and a substrate holding device body having a space to accommodate the elastic pad and the support member. The substrate holding device may further include an abutment member attached to the support member. The abutment member may have an elastic membrane brought into contact with the elastic pad. The substrate holding device may include a first pressure chamber defined between the substrate holding device body and the support member, a second pressure chamber defined outside of the abutment member between the elastic pad and the support member, and a third pressure chamber defined inside of the abutment member. The first pressure chamber, the second pressure chamber, and the third pressure chamber may be independently connected to the fluid supply source and/or the vacuum source.

According to the present invention, after a polishing process of a substrate such as a semiconductor wafer is completed, the substrate can quickly and reliably be separated from a substrate holding device. Further, the substrate can safely be removed from the substrate holding device without an excessive force being applied to the substrate. Furthermore, the substrate is subjected to no impact when it is transferred from the substrate holding device to a substrate relay device. Accordingly, the substrate is prevented from being damaged or broken. Thus, the yield can be improved. Further, since the substrate can quickly be removed from the substrate holding device, the throughput can be improved. Furthermore, since impact is reduced when the substrate is transferred to the substrate relay device, the yield can be improved remarkably in a process employing a low-k material.

The above and other objects, features, and advantages of the present invention will be apparent from the following description when taken in conjunction with the accompanying drawings which illustrate preferred embodiments of the present invention by way of example.

### Brief Description of Drawings

FIG. 1 is a schematic view showing an entire arrangement of a polishing apparatus according to an embodiment of the present invention;
FIG. 2 is a vertical cross-sectional view of a top ring in the polishing apparatus shown in FIG. 1;
FIG. 3 is a bottom view of the top ring shown in FIG. 2;
FIG. 4 is a perspective view showing a relationship between a pusher, the top ring, and a linear transporter in the polishing apparatus shown in FIG. **1**;
FIG. 5 is a vertical cross-sectional view showing details of the pusher in the polishing apparatus shown in FIG. 1;
FIGS. 6A through 6E are vertical cross-sectional views explanatory of operation of the pusher shown in FIG. 5;
FIG. 7 is a cross-sectional view schematically showing a pusher according to a first embodiment of the present invention;
FIG. 8 is a cross-sectional view schematically showing an attraction pad of the pusher shown in FIG. 7;
FIGS. 9A through 9D are vertical cross-sectional views explanatory of operation of the pusher shown in FIG. 7;
FIG. 10 is a cross-sectional view schematically showing a pusher according to a second embodiment of the present invention;
FIGS. 11A through 11F are vertical cross-sectional views explanatory of operation of the pusher shown in FIG. 10;
FIG. 12 is a cross-sectional view schematically showing a pusher according to a third embodiment of the present invention;
FIGS. 13A through 13C are vertical cross-sectional views explanatory of operation of the pusher shown in FIG. 12;
FIG. 14 is a cross-sectional view schematically showing a pusher according to a fourth embodiment of the present invention;
FIGS. 15A and 15B are vertical cross-sectional views explanatory of operation of the pusher shown in FIG. 14;
FIG. 16 is a cross-sectional view schematically showing a variation of the pusher shown in FIG. 14;
FIGS. 17A through 17C are vertical cross-sectional views explanatory of operation of the pusher shown in FIG. 16;
FIG. 18 is a cross-sectional view schematically showing a pusher according to a fifth embodiment of the present invention; and
FIGS. 19A and 19B are vertical cross-sectional views explanatory of operation of the pusher shown in FIG. 18.

### Best Mode for Carrying Out the Invention

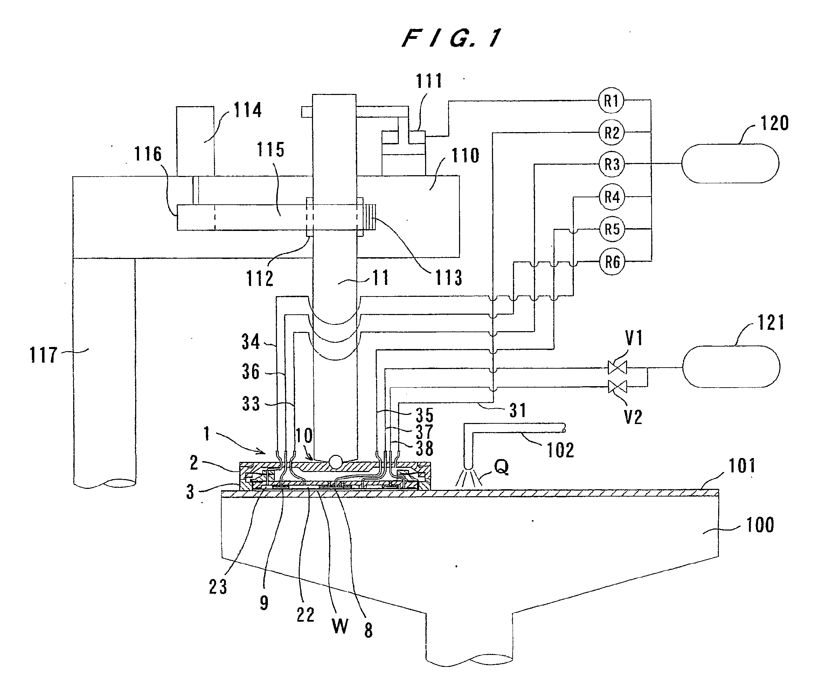

A polishing apparatus according to embodiments of the present invention will be described below with reference to FIGS. 1 through 19B.

FIG. 1 is a schematic view showing an entire arrangement of a polishing apparatus according to the present invention. As shown in FIG. 1, the polishing apparatus has a top ring 1 serving as a substrate holding device for holding a substrate such as a semiconductor wafer, and a polishing table 100 provided underneath the top ring 1. The polishing table 100 has a polishing pad 101 attached on an upper surface thereof. The polishing pad 101 serves as a polishing surface. The polishing apparatus includes a polishing liquid supply nozzle 102 provided above the polishing table 100 for supplying a polishing liquid Q onto the polishing pad 101.

Various kinds of polishing pads are available on the market. For example, some of these are SUBA800, IC-1000, and IC-1000/SUBA400 (two-layer layer cloth) manufactured by Rodel Inc., and Surfin xxx-5 and Surfin 0O0 manufactured by Fujimi Inc. SUBA800, Surfin xxx-5, and Surfin 000 are non-woven fabrics bonded by urethane resin, and IC-1000 is made of rigid foam polyurethane (single layer). Foam polyurethane is porous and has a large number of fine recesses or holes formed in its surface.

Although the polishing pad serves as the polishing surface, the polishing surface is not limited to the polishing pad. For example, the polishing surface may be constituted by a fixed abrasive. The fixed abrasive is formed into a flat plate comprising abrasive particles fixed by a binder. With the fixed abrasive for polishing, the polishing process is performed by abrasive particles that are self-generated from the fixed abrasive. The fixed abrasive comprises abrasive particles, a binder, and pores. For example, cerium dioxide (CeO₂), silicon oxide (SiO₂) or alumina (Al₂O₃) having an average particle diameter of 0.5 µm or less is used as abrasive particles, and thermosetting resin such as epoxy resin or urethane resin or thermoplastic resin such as MBS resin or ABS resin is used as a binder. Such a fixed abrasive forms a harder polishing surface. The fixed abrasive includes a fixed abrasive pad having a two-layer structure formed by a thin layer of a fixed abrasive and an elastic polishing pad attached to a lower surface of the thin layer of the fixed abrasive.

The top ring 1 is connected to a top ring drive shaft 11 by a universal **j** oint 10, and the top ring drive shaft 11 is coupled to a top ring air cylinder 111 fixed to a top ring head 110. The top ring air cylinder 111 is actuated to move the top ring drive shaft 11 vertically to thereby lift and lower the top ring 1 as a whole and to press a retainer ring 3 fixed to a lower end of a top ring body 2 against the polishing table 100. The top ring air cylinders. 111 is connected to a compressed air source (fluid-supply source) 120 via a regulator R1, which can regulate pressure of compressed air or the like which is supplied to the top ring air cylinder 111. Thus, it is possible to adjust a pressing force to press the polishing pad 101 with the retainer ring 3.

The top ring drive shaft 11 is connected to a rotary sleeve 112 by a key (not shown). The rotary sleeve 112 has a timing pulley 113 fixedly disposed at a peripheral portion thereof. A top ring motor 114 is fixed to the top ring head 110, and the timing pulley 113 is coupled to a timing pulley 116 mounted on the top ring motor 114 via a timing belt 115. Therefore, when the top ring motor 114 is energized for rotation, the rotary sleeve 112 and the top ring drive shaft 11 are rotated in unison with each other via the timing pulley 116, the timing belt 115, and the timing pulley 113 to thereby rotate the top ring 1. The top ring head 110 is supported on a top ring head shaft 117 fixedly supported on a frame (not shown). The top ring head shaft 117 is rotatable about its axis. When the top ring head shaft 117 is rotated, the top ring 1 is angularly moved between a polishing position on the polishing table 100 and a pusher, which is described later.

There will be described below the top ring 1 as the substrate holding device.

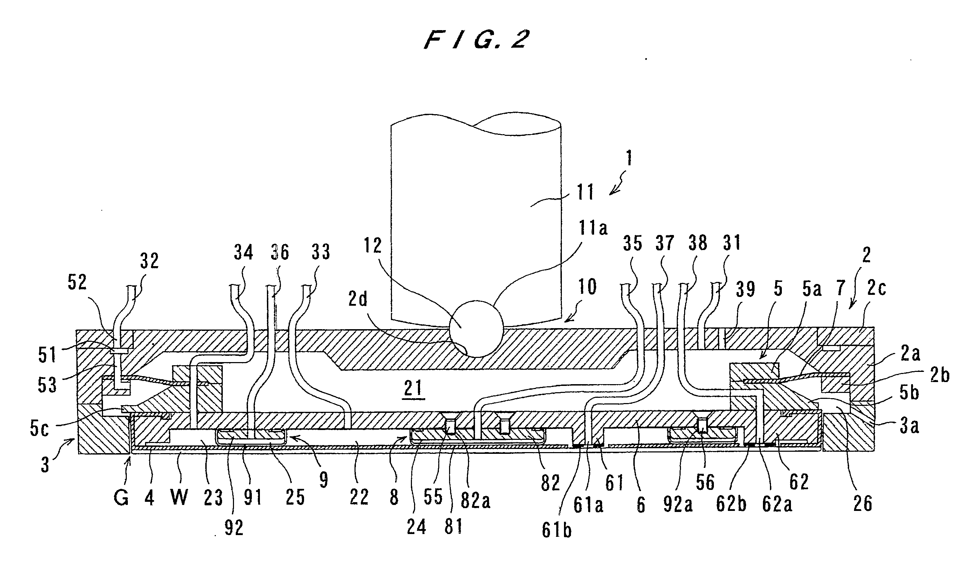

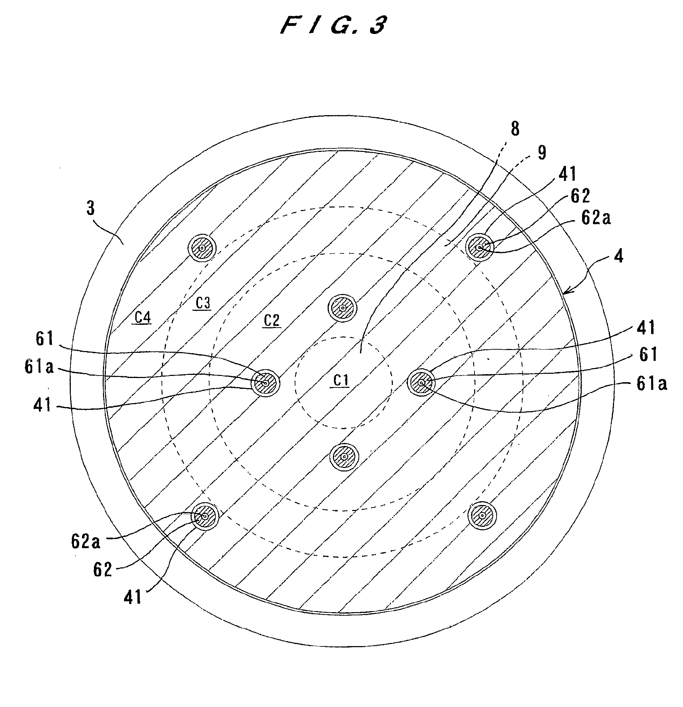

FIG. 2 is a vertical cross-sectional view showing the top ring 1, and FIG. 3 is a bottom view of the top ring 1 shown in FIG. 2. As shown in FIG. 2, the top ring 1 as a substrate holding device has a top ring body 2 in the form of a cylindrical housing with a receiving space defined therein, and a retainer ring 3 fixed to the lower end of the top ring body 2. The top ring body 2 is made of a material having high strength and rigidity, such as metal or ceramics. The retainer ring 3 is made of highly rigid synthetic resin, ceramics, or the like.

The top ring body 2 includes a cylindrical housing 2a, an annular pressurizing sheet support 2b fitted into the cylindrical portion of the housing 2a, and an annular seal 2c fitted over an outer circumferential edge of an upper surface of the housing 2a. The retainer ring 3 is fixed to the lower end of the housing 2a of the top ring body 2. The retainer ring 3 has a lower portion projecting radially inward. The retainer ring 3 may be formed integrally with the top ring body 2.

The top ring drive shaft 11 is disposed above the central portion of the housing 2a of the top ring body 2, and the top ring body 2 is coupled to the top ring drive shaft 11 by the universal joint 10. The universal joint 10 has a spherical bearing mechanism by which the top ring body 2 and the top ring drive shaft 11 are tiltable with respect to each other, and a rotation transmitting mechanism for transmitting the rotation of the top ring drive shaft 11 to the top ring body 2. The spherical bearing mechanism and the rotation transmitting mechanism transmit a pressing force and a rotating force from the top ring drive shaft 11 to the top ring body 2 while allowing the top ring body 2 and the top ring drive shaft 11 to be tilted with respect to each other.

The spherical bearing mechanism includes a hemispherical concave recess 11a defined centrally in the lower surface of the top ring drive shaft 11, a hemispherical concave recess 2d defined centrally in the upper surface of the housing 2a, and a bearing ball 12 made of a highly hard material such as ceramics and interposed between the concave recesses 11a and 2d. Meanwhile, the rotation transmitting mechanism includes drive pins (not shown) fixed to the top ring drive shaft 11, and driven pins (not shown) fixed to the housing 2a. Even if the top ring body 2 is tilted with respect to the top ring drive shaft 11, the drive pins and the driven pins remain in engagement with each other while contact points are displaced because the drive pin and the driven pin are vertically movable relative to each other. Thus, the rotation transmitting mechanism reliably transmits rotational torque of the top ring drive shaft 11 to the top ring body 2.

The top ring body 2 and the retainer ring 3 secured to the top ring body 2 have a space defined therein, which accommodates therein an elastic pad (membrane) 4 having a lower surface (substrate holding surface) brought into contact with the semiconductor wafer W held by the top ring 1, an annular holder ring 5, and a disk-shaped subcarrier plate 6 (support member) for supporting the elastic pad 4. The elastic pad 4 has a radially outer edge clamped between the holder ring 5 and the subcarrier plate 6 secured to the lower end of the holder ring 5 and extends radially inward so as to cover the lower surface of the subcarrier plate 6. Thus, a space is defined between the elastic pad 4 and the subcarrier plate 6.

The subcarrier plate 6 may be made of metal. However, when the thickness of a thin film formed on a surface of a semiconductor wafer is measured by a method using eddy current in a state such that a semiconductor wafer to be polished is held by the top ring, the subcarrier plate 6 should preferably be made of a non-magnetic material, e.g., an insulating material such as fluororesin or ceramics.

A pressurizing sheet 7 comprising an elastic membrane extends between the holder ring 5 and the top ring body 2. The pressurizing sheet 7 has a radially outer edge clamped between the housing 2a and the pressurizing sheet support 2b of the top ring body 2, and a radially inner edge clamped between an upper end portion 5a and a stopper 5b of the holder ring 5. The top ring body 2, the subcarrier plate 6, the holder ring 5, and the pressurizing sheet 7 jointly define a pressure chamber 21 (first pressure chamber) in the top ring body 2. A fluid passage 31 comprising tubes and connectors communicates with the pressure chamber 21, which is connected to the compressed air source 120 via a regulator R2 provided on the fluid passage 31 as shown in FIG. 1. The pressurizing sheet 7 is made of a highly strong and durable rubber material such as ethylene propylene rubber (EPDM), polyurethane rubber, or silicone rubber.

In the case where the pressurizing sheet 7 is made of an elastic material such as rubber, if the pressurizing sheet 7 is fixedly clamped between the retainer ring 3 and the top ring body 2, then a desired horizontal surface cannot be maintained on the lower surface of the retainer ring 3 because of elastic deformation of the pressurizing sheet 7 as an elastic material. In order to prevent such a drawback, the pressurizing sheet 7 is clamped between the housing 2a of the top ring body 2 and the pressurizing sheet support 2b provided as a separate member in the present embodiment. As disclosed by Japanese laid-open patent application Nos. 09-168964 and 2001-179605, the retainer ring 3 may be movable vertically with respect to the top ring body 2, or the retainer ring 3 may have a structure capable of pressing the polishing surface independently of the top ring body 2. In such cases, the pressurizing sheet 7 is not necessarily fixed in the aforementioned manner.

A cleaning liquid passage 51 in the form of an annular groove is defined in the upper surface of the housing 2a near its outer circumferential edge over which the seal 2c of the top ring body 2 is fitted. The cleaning liquid passage 51 communicates with a fluid passage 32 through a through-hole 52 formed in the seal 2c, and is supplied with a cleaning liquid (pure water) through the fluid passage 32. A plurality of communication holes 53 are defined in the housing 2a and the pressurizing sheet support 2b in communication with the cleaning liquid passage 51. The communication holes 53 communicate with a small gap G defined between the outer circumferential surface of the elastic pad 4 and the inner circumferential surface of the retainer ring 3.

A central bag 8 and a ring tube 9 which serve as abutment members brought into contact with the elastic pad 4 are mounted in a space defined between the elastic pad 4 and the subcarrier plate 6. In the present embodiment, as shown in FIGS. 2 and 3, the central bag 8 is disposed centrally on the lower surface of the subcarrier plate 6, and the ring tube 9 is disposed radially outward of the central bag 8 in surrounding relation thereto. Each of the elastic pad 4, the central bag 8, and the ring tube 9 is made of a highly strong and durable rubber material such as ethylene propylene rubber (EPDM), polyurethane rubber, or silicone rubber.

The space defined between the subcarrier plate 6 and the elastic pad 4 is divided into a plurality of spaces (second pressure chamber) by the central bag 8 and the ring tube 9. Accordingly, a pressure chamber 22 is defined between the central bag 8 and the ring tube 9, and a pressure chamber 23 is defined radially outward of the ring tube 9.

The central bag 8 includes an elastic membrane 81 brought into contact with the upper surface of the elastic pad 4, and a central bag holder 82 for detachably holding the elastic membrane 81 in position. The central bag holder 82 has threaded holes 82a defined therein, and the central bag 8 is detachably fastened to the center of the lower surface of the subcarrier plate 6 by screws 55 threaded into the threaded holes 82a. The central bag 8 has a central pressure chamber 24 (third pressure chamber) defined therein by the elastic membrane 81 and the central bag holder 82.

Similarly, the ring tube 9 comprises an elastic membrane 91 brought into contact with the upper surface of the elastic pad 4, and a ring tube holder 92 for detachably holding the elastic membrane 91 in position. The ring tube holder 92 has threaded holes 92a defined therein, and the ring tube 9 is detachably fastened to the lower surface of the subcarrier plate 6 by screws 56 threaded into the threaded holes 92a. The ring tube 9 has an intermediate pressure chamber 25 (third pressure chamber) defined therein by the elastic membrane 91 and the ring tube holder 92.

Fluid passages 33, 34, 35 and 36 comprising tubes and connectors communicate with the pressure chambers 22 and 23, the central pressure chamber 24, and the intermediate pressure chamber 25, respectively. As shown in FIG. 1, the pressure chambers 22-25 are connected to the compressed air source 120 as a fluid supply source via respective regulators R3, R4, R5 and R6 connected respectively to the fluid passages 33-36. The fluid passages 31 to 36 are connected to the respective regulators R1 to R6 through a rotary joint (not shown) mounted on the upper end of the top ring shaft 110.

The pressure chamber 21 above the subcarrier plate 6 and the pressure chambers 22-25 are supplied with pressurized fluids such as pressurized air or atmospheric air or evacuated, via the fluid passages 31, 33, 34, 35 and 36 connected to the respective pressure chambers. As shown in FIG. 1, the regulators R2-R6 connected to the fluid passages 31, 33, 34, 35 and 36 of the pressure chambers 21-25 can respectively regulate the pressures of the pressurized fluids supplied to the respective pressure chambers. Thus, it is possible to independently control the pressures in the pressure chambers 21-25 or independently introduce atmospheric air or vacuum into the pressure chambers 21-25. In this manner, the pressures in the pressure chambers 21-25 are independently varied with the regulators R2-R6, so that the pressing forces to press the semiconductor wafer W via the elastic pad 4 against the polishing pad 101 can be adjusted in local areas of the semiconductor wafer W. In some applications, the pressure chambers 21-25 may be connected to a vacuum source 121 such as a vacuum pump.

In this case, the pressurized fluid or the atmospheric air supplied to the pressure chambers 22-25 may independently be controlled in temperature. With this configuration, it is possible to directly control the temperature of a substrate such as a semiconductor wafer from the backside of the surface to be polished. Particularly, when each of the pressure chambers is independently controlled in temperature, the rate of chemical reaction can be controlled in the chemical polishing process of CMP.

As shown in FIG. 3, the elastic pad 4 has a plurality of openings 41. Inner suction portions 61 project downward from the subcarrier plate 6 so as to be exposed through the respective openings 41 which are positioned between the central bag 8 and the ring tube 9. Outer suction portions 62 project downward from the subcarrier plate 6 so as to be exposed through the respective openings 41 which are positioned radially outward of the ring tube 9. In this embodiment, the elastic pad 4 has eight openings 41, and the suction portions 61 and 62 are exposed through these openings 41.

The inner suction portions 61 and the outer suction portions 62 have communication holes 61a and 62a communicating with fluid passages 37 and 38, respectively. The suction portions 61 and 62 are connected to the vacuum source 121 such as a vacuum pump via the fluid passages 37 and 38 and valves V1 and V2. When the communication holes 61a and 62a of the suction portions 61 and 62 are connected to the vacuum source 121, a negative pressure is developed at the lower opening ends of the communication holes 61a and 62a thereof to attract a semiconductor wafer W to the lower ends of the suction portions 61 and 62. The suction portions 61 and 62 have elastic sheets 61b, 62b, such as thin rubber sheets, attached to their lower ends, for thereby elastically contacting and holding the semiconductor wafer W on the lower surfaces thereof.

As shown in FIG. 2, while the semiconductor wafer W is being polished, the suction portions 61 and 62 are positioned above the lower surface of the elastic pad 4, and thus do not project from the lower surface of the elastic pad 4. When attracting the semiconductor wafer W, the lower end surfaces of the suction portions 61 and 62 are positioned substantially in the same plane as the lower surface of the elastic pad 4.

Since there is a small gap G between the outer circumferential surface of the elastic pad 4 and the inner circumferential surface of the retainer ring 3, the holder ring 5, the subcarrier plate 6, and the elastic pad 4 attached to the subcarrier plate 6 can be moved vertically with respect to the top ring body 2 and the retainer ring 3, and hence are of a floating structure with respect to the top ring body 2 and the retainer ring 3. The stopper 5b of the holder ring 5 has a plurality of teeth 5c projecting radially outward from the outer circumferential edge thereof. Downward movement of the members including the holder ring 5 is limited to a predetermined range by engaging the teeth 5c with the upper surface of the radially inward projecting portion of the retainer ring 3.

Next, operation of the top ring 1 thus constructed will be described in detail below.

In the polishing apparatus constructed above, when a semiconductor wafer W is to be delivered to the polishing table 100, the top ring 1 as a whole is moved to the pusher, which is described later, and the communication holes 61a and 62a of the suction portions 61 and 62 are connected via the fluid passages 37 and 38 to the vacuum source 121. The semiconductor wafer W is attracted under vacuum to the lower ends of the suction portions 61 and 62 by suction effect of the communication holes 61a and 62a. With the semiconductor wafer W attracted to the top ring 1, the top ring 1 as a whole is moved to a position above the polishing table 100 having the polishing surface (polishing pad 101) thereon. The outer circumferential edge of the semiconductor wafer W is held by the retainer ring 3 so that the semiconductor wafer W is not removed from the top ring 1.

For polishing the semiconductor wafer W, the attraction of semiconductor wafer W by the suction portions 61 and 62 is released, and the semiconductor wafer W is held on the lower surface of the top ring 1. Simultaneously, the top ring air cylinder 111 connected to the top ring drive shaft 11 is actuated to press the retainer ring 3 fixed to the lower end of the top ring 1 against the polishing surface on the polishing table 100 under a predetermined pressure. In such a state, pressurized fluids are respectively supplied to the pressure chambers 22, 23, the central pressure chamber 24, and the intermediate pressure chamber 25 under respective pressures, thereby pressing the semiconductor wafer W against the polishing surface on the polishing table 100. The polishing liquid supply nozzle 102 supplies a polishing liquid Q onto the polishing pad 101 in advance, so that the polishing liquid Q is held on the polishing pad 101. Thus, the semiconductor wafer W is polished by the polishing pad 101 with the polishing liquid Q being present between the (lower) surface, to be polished, of the semiconductor wafer W and the polishing pad 101.

The local areas of the semiconductor wafer W that are positioned beneath the pressure chambers 22 and 23 are pressed against the polishing surface under the pressures of the pressurized fluids supplied to the pressure chambers 22 and 23. The local area of the semiconductor wafer W that is positioned beneath the central pressure chamber 24 is pressed via the elastic membrane 81 and the elastic pad 4 of the central bag 8 against the polishing surface under the pressure of the pressurized fluid supplied to the central pressure chamber 24. The local area of the semiconductor wafer W that is positioned beneath the intermediate pressure chamber 25 is pressed via the elastic membrane 91 and the elastic pad 4 of the ring tube 9 against the polishing surface under the pressure of the pressurized fluid supplied to the intermediate pressure chamber 25.

Therefore, the polishing pressures acting on the respective local areas of the semiconductor wafer W can be adjusted independently by controlling the pressures of the pressurized fluids supplied to the respective pressure chambers 22-25. Specifically, the respective regulators R3-R6 independently regulate the pressures of the pressurized fluids supplied to the pressure chambers 22-25 for thereby adjusting the pressing forces applied to press the local areas of the semiconductor wafer W against the polishing pad 101 on the polishing table 100. With the polishing pressures on the respective local areas of the semiconductor wafer W being adjusted independently to desired values, the semiconductor wafer W is pressed against the polishing pad 101 on the polishing table 100 that is being rotated. Similarly, the pressure of the pressurized fluid supplied to the top ring air cylinder 111 can be regulated by the regulator R1 to adjust the force with which the retainer ring 3 presses the polishing pad 101. While the semiconductor wafer W is being polished, the force with which the retainer ring 3 presses the polishing pad 101 and the pressing force with which the semiconductor wafer W is pressed against the polishing pad 101 can appropriately be adjusted for thereby applying polishing pressures in a desired pressure distribution to a central area (C1 in FIG. 3), an inner area (C2) between the central area and an intermediate area, the intermediate area (C3), a peripheral area (C4) of the semiconductor wafer W, and a peripheral portion of the retainer ring 3 which is positioned outside of the semiconductor wafer W.

The semiconductor wafer W has a portion positioned beneath the pressure chambers 22 and 23. In this portion, there exist two areas. One is pressed by the pressurized fluid through the elastic pad 4, and the other is pressed directly by the pressurized fluid. The latter is an area whose position corresponds to the opening 41. These two areas may be pressed under the same pressing force. Since, the elastic pad 4 is held in intimate contact with the reverse side of the semiconductor wafer W near the openings 41, the pressurized fluids in the pressure chambers 22 and 23 are essentially prevented from leaking to the exterior.

In this manner, the semiconductor wafer W is divided into the four concentric circular and annular areas (C1 to C4), which can respectively be pressed under independent pressing forces. A polishing rate depends on a pressing force applied to a semiconductor wafer W against a polishing surface. As described above, since the pressing forces applied to those areas can independently be controlled, the polishing rates of the four circular and annular areas (C1 to C4) of the semiconductor wafer W can independently be controlled. Consequently, even if the thickness of a thin film to be polished on the surface of the semiconductor wafer W suffers radial variations, the thin film on the surface of the semiconductor wafer W can be polished uniformly without being insufficiently or excessively polished over the entire surface of the semiconductor wafer. More specifically, even if the thickness of the thin film to be polished on the surface of the semiconductor wafer W differs depending on the radial position on the semiconductor wafer W, the pressure in a pressure chamber positioned over a thicker area of the thin film is made higher than the pressure in other pressure chambers, or the pressure in a pressure chamber positioned over a thinner area of the thin film is made lower than the pressure in other pressure chambers. In this manner, the pressing force applied to the thicker area of the thin film against the polishing surface is made higher than the pressing force applied to the thinner area of the thin film against the polishing surface, thereby selectively increasing the polishing rate of the thicker area of the thin film. Consequently, the entire surface of the semiconductor wafer W can be polished exactly to a desired level over the entire surface of the semiconductor wafer W irrespective of the film thickness distribution produced at the time the thin film is formed.

Any unwanted edge rounding on the circumferential edge of the semiconductor wafer W can be prevented by controlling the pressing force applied to the retainer ring 3. If the thin film to be polished on the circumferential edge of the semiconductor wafer W has large thickness variations, then the pressing force applied to the retainer ring 3 is intentionally increased or reduced to thus control the polishing rate of the circumferential edge of the semiconductor wafer W. When the pressurized fluids are supplied to the pressure chambers 22-25, the subcarrier plate 6 is subjected to upward forces. In the present embodiment, the pressurized fluid is supplied to the pressure chamber 21 via the fluid passage 31 to prevent the subcarrier plate 6 from being lifted under the forces due to the pressure chambers 22-25.

As described above, the pressing force applied by the top ring air cylinder 111 to press the retainer ring 3 against the polishing pad 101 and the pressing forces applied by the pressurized air supplied to the pressure chambers 22-25 to press the local areas of the semiconductor wafer W against the polishing pad 101 are appropriately adjusted to polish the semiconductor wafer W. When the polishing of the semiconductor wafer W is finished, the semiconductor wafer W is attracted to the lower ends of the suction portions 61 and 62 under vacuum in the same manner as described above. At this time, the supply of the pressurized fluids into the pressure chambers 22-25 to press the semiconductor wafer W against the polishing surface is stopped, and the pressure chambers 22-25 are vented to the atmosphere. Accordingly, the lower ends of the suction portions 61 and 62 are brought into contact with the semiconductor wafer W. The pressure chamber 21 is vented to the atmosphere or evacuated to develop a negative pressure therein. If the pressure chamber 21 is maintained at a high pressure, then the semiconductor wafer W is strongly pressed against the polishing surface only in areas brought into contact with the suction portions 61 and 62. Therefore, it is necessary to decrease the pressure in the pressure chamber 21 immediately. Accordingly, as shown in FIG. 2, a relief port 39 penetrating from the pressure chamber 21 through the top ring body 2 may be provided for decreasing the pressure in the pressure chamber 21 immediately. In this case, when the pressure chamber 21 is pressurized, it is necessary to continuously supply the pressurized fluid into the pressure chamber 21 via the fluid passage 31. The relief port 39 has a check valve for preventing an outside air from flowing into the pressure chamber 21 at the time when a negative pressure is developed in the pressure chamber 21.

After attraction of the semiconductor wafer W, the top ring 1 as a whole is moved to a position to which the semiconductor wafer W is to be transferred, and then a fluid (e.g., compressed air or a mixture of nitrogen and pure water) is ejected to the semiconductor wafer W via the communication holes 61a and 62a of the suction portions 61 and 62 to release the semiconductor wafer W from the top ring 1.

The polishing liquid Q used to polish the semiconductor wafer W tends to flow through the small gap G between the outer circumferential surface of the elastic pad 4 and the retainer ring 3. If the polishing liquid Q is firmly deposited in the gap G, then the holder ring 5, the subcarrier plate 6, and the elastic pad 4 are prevented from smoothly moving vertically with respect to the top ring body 2 and the retainer ring 3. To avoid such a drawback, a cleaning liquid (pure water) is supplied through the fluid passage 32 to the cleaning liquid passage 51. Accordingly, the pure water is supplied via a plurality of communication holes 53 to a region above the gap G, thus cleaning the gap G to prevent the polishing liquid Q from being firmly deposited in the gap G. The pure water should preferably be supplied after the polished semiconductor wafer W is released and until a next semiconductor wafer to be polished is attracted to the top ring 1. It is also preferable to discharge all the supplied pure water out of the top ring 1 before the next semiconductor wafer is polished, and hence to provide the retainer ring 3 with a plurality of through-holes 3a shown in FIG. 2. Furthermore, if a pressure buildup is developed in a space 26 defined between the retainer ring 3, the holder ring 5, and the pressurizing sheet 7, then it acts to prevent the subcarrier plate 6 from being elevated in the top ring body 2. Therefore, in order to allow the subcarrier plate 6 to be elevated smoothly in the top ring body 2, the through-holes 3a should preferably be provided for equalizing the pressure in the space 26 with the atmospheric pressure.

As described above, the pressures in the pressure chambers 22, 23, the pressure chamber 24 in the central bag 8, and the pressure chamber 25 in the ring tube 9 are independently controlled to control the pressing forces acting on the semiconductor wafer W. Further, it is possible to easily change areas in which the pressing force is controlled by changing positions and sizes of the central bag 8 and the ring tube 9.

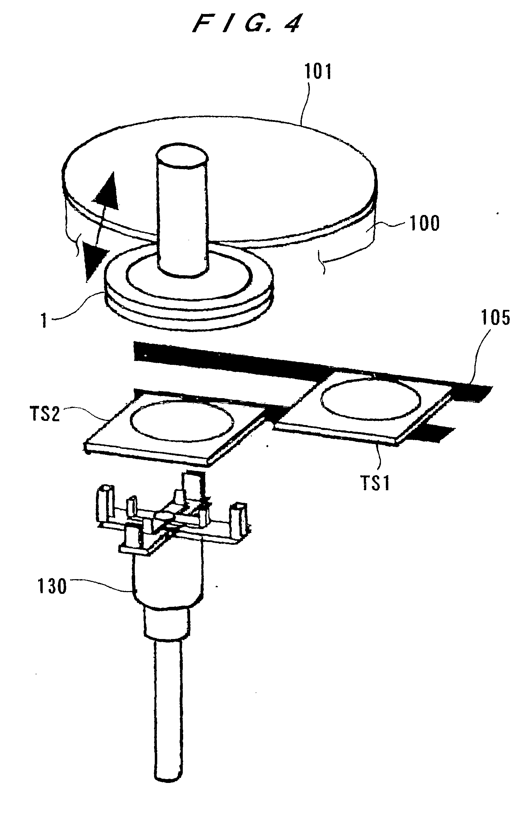

There will be described below a pusher, which serves as a substrate relay device to transfer a semiconductor wafer between the top ring 1 and a linear transporter. FIG. 4 is a perspective view showing a relationship between a pusher 130, the top ring 1, and a linear transporter 105. The pusher 130 serves to receive a semiconductor wafer from a first transfer stage TS1 of the linear transporter 105 and deliver the semiconductor wafer to the top ring 1, and also serves to receive a polished semiconductor wafer from the polishing table 100 via the top ring 1 and deliver the semiconductor wafer to a second transfer stage TS2 of the linear transporter 105. Thus, the pusher 130 serves as a receiving/delivering mechanism for receiving and delivering semiconductor wafers between the linear transporter 105 and the top ring 1.

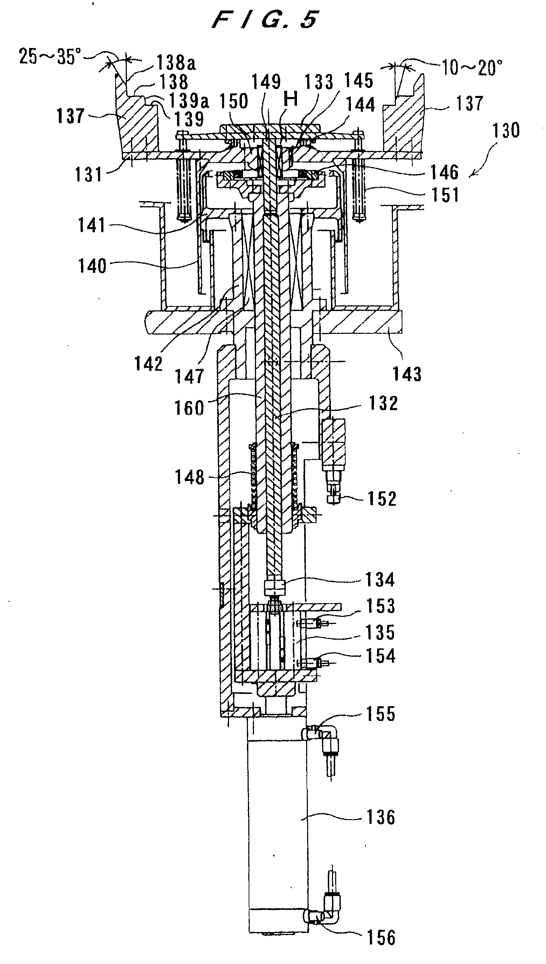

FIG. 5 is a vertical cross-sectional view showing details of the pusher 130. As shown in FIG. 5, the pusher 130 has a guide stage 131 provided above a hollow shaft 160 for holding the top ring, a spline shaft 132 extending through the hollow shaft 160, and a push stage 133 provided above the spline shaft 132 for holding a semiconductor wafer thereon. The push stage 133 serves as a substrate placement section having a substrate placement surface on which a semiconductor wafer is placed. Air cylinders 135 and 136 are coupled to the spline shaft 132 through a floating joint 134, which can flexibly be connected to the shaft against displacement of the shaft. The two air cylinders 135 and 136 are disposed vertically in series.

The lower air cylinder 136 serves to lift and lower the guide stage 131 and the push stage 133. The lower air cylinder 136 lifts and lowers the hollow shaft 160 together with the upper air cylinder 135. The air cylinder 135 serves as a moving mechanism to lift and lower the push stage 133.

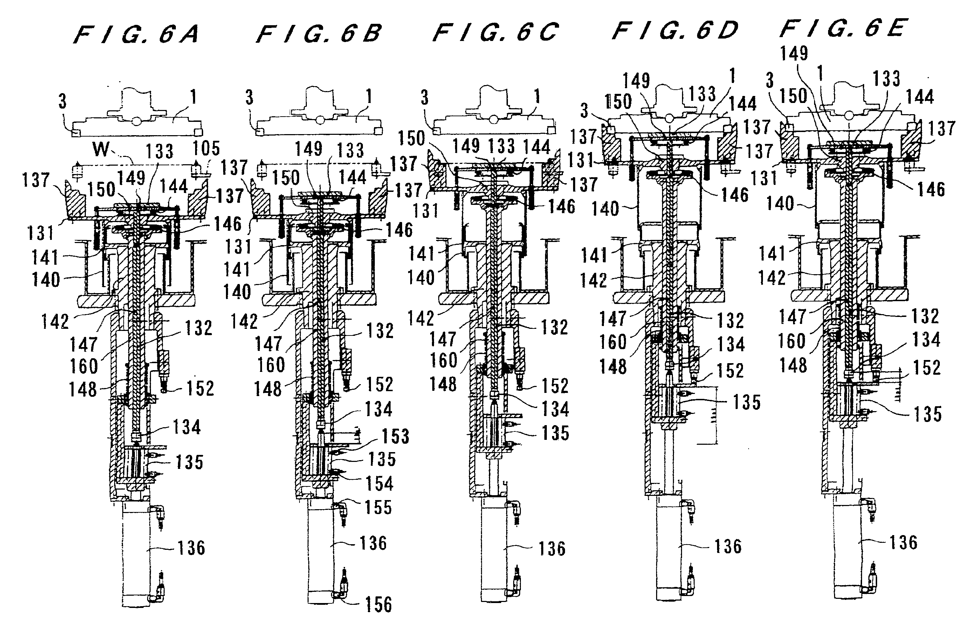

Four top ring guides 137 are provided at an outer circumferential portion of the guide stage 131. The top ring guide 137 has a two-stage structure including an upper stage 138 and a lower stage 139. The upper stages 138 of the top ring guides 137 serve as contact portions with a lower surface of the retainer ring 3 (see FIG. 6) of the top ring, whereas the lower stages 139 serve as centering portions for centering a semiconductor wafer and support portions for supporting the semiconductor wafer. The upper stage 138 has a tapered surface 138a, formed preferably at an angle of about 25° to about 35°, for guiding the top ring toward the upper stage 138. The lower stage 139 has a tapered surface 139a, formed preferably at an angle of about 10° to about 20°, for guiding the semiconductor wafer W toward the lower stage 139. When the semiconductor wafer is unloaded from the top ring, the top ring guides 137 directly receive a peripheral edge of the semiconductor wafer.

A guide sleeve 140 having a water proof function and a function for guiding the guide stage 131 so as to be returned to its original position is provided below the guide stage 131. A center sleeve 141 for centering the pusher is fixed to a bearing case 142 located inside of the guide sleeve 140. The pusher 130 is connected through the bearing case 142 to a motor housing 143 in a polishing section.

Further, a V-ring 144 is used to prevent water from entering between the push stage 133 and the guide stage 131. The V-ring 144 has a lip held in contact with the guide stage 131 to prevent water from passing therethrough. When the guide stage 131 is lifted, the volume of a portion H is increased to lower the pressure in the portion H so as to draw water into the portion H. In order to prevent water from being drawn into the portion H, a hole 145 is defined in an inner side of the V-ring 144 for preventing the pressure in the portion H from being lowered.

The pusher 130 has a linear way 146 movable in directions of an X-axis and a Y-axis for allowing the top ring guides 137 to have an alignment mechanism. The guide stage 131 is fixed to the linear way 146. The linear way 146 is fixed to the hollow shaft 160. The hollow shaft 160 is held through a slide bush 147 by the bearing case 142. The stroke of the air cylinder 136 is transmitted through a compression spring 148 to the hollow shaft 160.

The push stage 133 is located above the guide stage 131. The push stage 133 has a push rod 149 extending downward from the center of the push stage 133. The push rod 149 extends through a slide bush 150 located at the center of the guide stage 131 so that the push rod 149 is centered. The push rod 149 is brought into contact with an upper end of the spline shaft 132. The push stage 133 is vertically moved by the spline shaft 132 with the cylinder 135 so that the semiconductor wafer W is loaded on the top ring 1. The push stage 133 has compression springs 151 provided at a peripheral portion thereof for positioning the push stage 133.

A shock killer 152 is provided for positioning the top ring guides 137 in a vertical direction and for shock-absorbing when the top ring guides 137 contact the top ring 1. Each of the air cylinders has upper and lower limit sensors for detecting a position of the pusher in a vertical direction. Specifically, the air cylinder 135 has sensors 153 and 154, and the air cylinder 136 has sensors 155 and 156. The pusher 130 has a cleaning nozzle for cleaning the pusher 130 so as to prevent slurry attached to the pusher from contaminating the semiconductor wafer. The pusher may have a sensor for detecting the presence of a semiconductor wafer positioned on the pusher. The air cylinders 135 and 136 are controlled by double solenoid valves, respectively.

Operation of the pusher 130 thus constructed will be described below. FIGS. 6A through 6E are views explanatory of operation of the pusher 130.

### 1) Loading a semiconductor wafer

As shown in FIG. 6A, a semiconductor wafer W is transferred to a position above the pusher 130 by the linear transporter 105. When the top ring 1 is located at a wafer loading position above the pusher 130 and does not hold the semiconductor wafer, the push stage 133 is lifted by the air cylinder 135, as shown in FIG. 6B. When the sensor 153 detects the completion of lifting the push stage 133, the guide stage 131 and the components associated with the guide stage 131 are lifted by the air cylinder 136, as shown in FIG. 6C. While the guide stage 131 is lifted, the guide stage 131 passes through the semiconductor wafer holding position of the transfer stage of the linear transporter 105. At that time, the semiconductor wafer W is centered by the tapered surfaces 139a of the top ring guides 137 and held by the push stage 133 at a pattern surface of the semiconductor wafer W (at portions other than the peripheral edge thereof).

While the push stage 133 holds the semiconductor wafer W, the top ring guides 137 are lifted without being stopped, and the retainer ring 3 is guided by the tapered surfaces 138a of the top ring guides 137. The center of the top ring guides 137 is aligned with the center of the top ring 1 by the linear way 146 movable in X and Y directions, and the upper stages 138 of the top ring guides 137 contact the lower surface of the retainer ring 3 and lifting of the guide stage 131 is stopped.

When the upper stages 138 of the top ring guides 137 are brought into contact with the lower surface of the retainer ring 3, the guide stage 131 is fixed and is not lifted anymore. However, the air cylinder 136 continues the lifting motion until the air cylinder 136 is brought into contact with the shock killer 152. Accordingly, only the spline shaft 132 continues to be lifted because the compression spring 148 is compressed, and the push stage 133 is further lifted. At that time, as shown in FIG. 6D, the push stage 133 holds the semiconductor wafer W at the pattern surface of the semiconductor wafer W (at portions other than the peripheral edge thereof), and transports the semiconductor wafer W to the top ring 1. After the semiconductor wafer W is brought into contact with the top ring 1, the lifting stroke of the cylinder 136 is absorbed by the springs 151 to thereby protect the semiconductor wafer W.

### 2) Unloading a semiconductor wafer

The semiconductor wafer W is transported by the top ring 1 to a wafer unloading position located above the pusher 130. When the transfer stage of the linear transporter 105 is located above the pusher 130 and does not hold the semiconductor wafer, the guide stage 131 and the components associated with the guide stage 131 are lifted by the air cylinder 136, and the retainer ring 3 is guided by the tapered surfaces 138a of the top ring guides 137. The center of the top ring guides 137 is aligned with the center of the top ring 1 by the linear way 146, and the upper stages 138 of the top ring guides 137 are brought into contact with the lower surface of the retainer ring 3 and the lifting of the guide stage 131 is stopped.

The air cylinder 136 continues to be actuated until the air cylinder 136 contacts the shock killer 152. However, since the upper stages 138 of the top ring guides 137 contact the lower surface of the retainer ring 3 to cause the guide stage 131 to be fixed at this position, the air cylinder 136 pushes the spline shaft 132 together with the air cylinder 135 against an urging force of the compression spring 148, thus lifting the push stage 333. At that time, as shown in FIG. 6E, the push stage 133 is not raised to a position higher than the semiconductor wafer holding portion of the lower stages 139 of the top ring guides 137. In this embodiment, the air cylinder 136 is arranged to be further actuated after the top ring guides 137 contact the retainer ring 3. The shock at that time is absorbed by the compression spring 148.

After the lifting actuation of the air cylinder 136 is completed, the semiconductor wafer W is released from the top ring 1. At that time, the semiconductor wafer W is centered by the lower tapered surfaces 139a of the top ring guides 137, and the semiconductor wafer W is held by the lower stages 139 of the top ring guides 137 at the peripheral edge of the semiconductor wafer W. After the semiconductor wafer W is held by the pusher 130, the pusher 130 starts to be lowered. While the guide stage 131 is lowered, the guide stage 131, which has moved its center for centering the top ring 1, is centered by the guide sleeve 140 and the center sleeve 141. While the guide stage 131 is lowered, the semiconductor wafer W is transferred from the pusher 130 to the linear transporter 105 at the peripheral edge thereof. When the lowering of the guide stage 131 is completed, the operation of the unloading of the semiconductor wafer is completed.

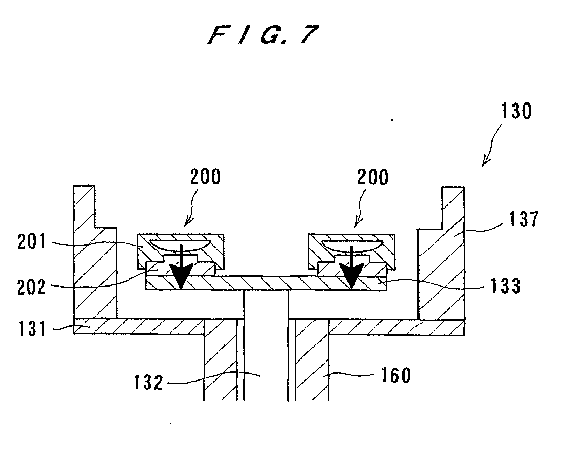

The pusher 130 shown in FIG. 5 has a mechanism for separating a polished semiconductor wafer reliably from the top ring 1 without any impact upon the semiconductor wafer when the semiconductor wafer is delivered from the top ring 1 to the pusher 130. Embodiments of such a mechanism will be described below with reference to FIGS. 7 through 19B.

FIG. 7 shows a pusher according to a first embodiment of the present invention. FIG. 7 is a cross-sectional view schematically showing the pusher 130 and illustrates only main part of the pusher 130. Thus, the pusher 130 is illustrated as including the guide stage 131, the top ring guides 137, the push stage 133, the spline shaft 132 to vertically move the push stage 133, and the hollow shaft 160. As shown in FIG. 7, the pusher 130 has one or more attraction pads 200 as an attraction section attached on an upper surface of the push stage 133.

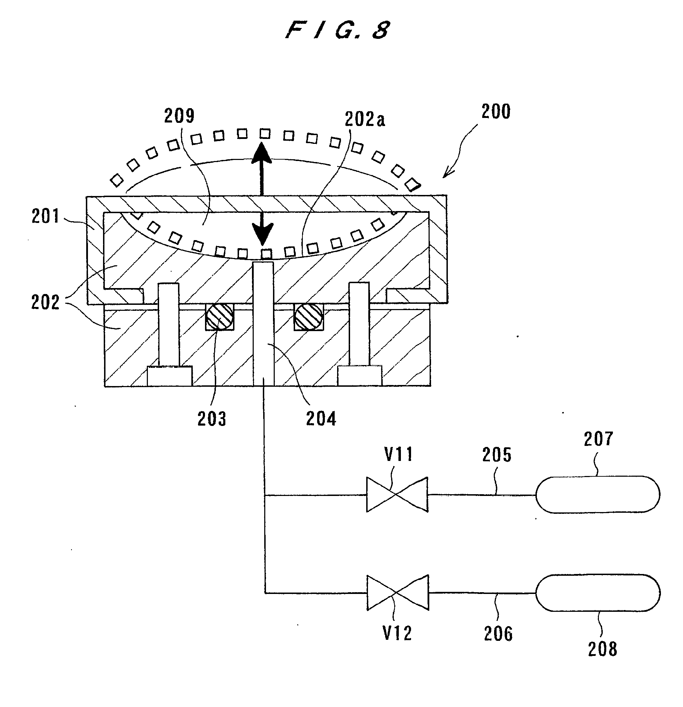

FIG. 8 is a cross-sectional view showing the attraction pad 200. As shown in FIG. 8, the attraction pad 200 has an elastic body or elastic membrane 201 in a form of a bag, and an attraction pad body 202 including upper and lower members which clamp open ends of the elastic membrane 201 therebetween. The upper member of the attraction pad body 202 has a recess 202a in a form of a hemisphere or a bowl formed in an upper surface (chamber surface) thereof. The recess 202a and the elastic membrane (elastic body) 201, which covers the recess 202a, define a fluid chamber 209. The attraction pad 200 includes an O-ring 203 interposed between the upper and lower members of the attraction pad body 202 for sealing an interface of the upper and lower members. The upper and lower members have a communication hole 204 opened to the recess 202a on the upper surface of the upper member. The communication hole 204 is connected through pipes 205 and 206 to a vacuum source 207 and a compressed fluid supply source 208. A valve V11 is provided on the pipe 205 which is connected to the vacuum source 207, and a valve V12 is provided on the pipe 206 which is connected to the compressed fluid supply source 208.

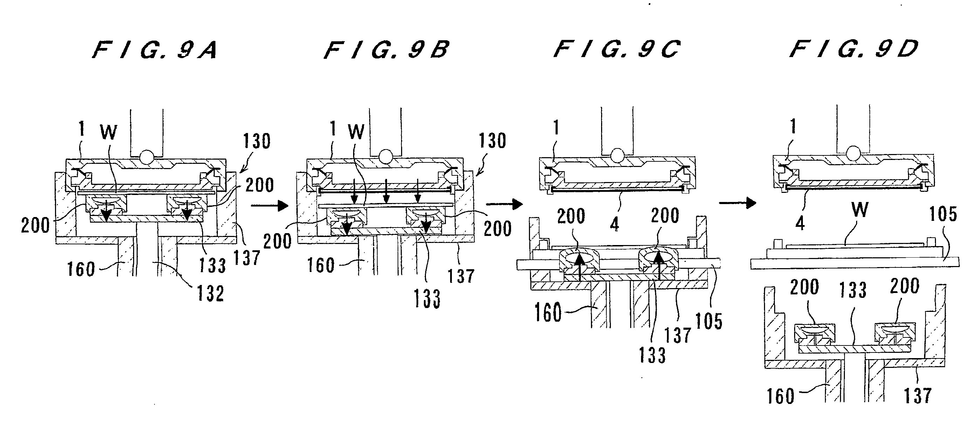

Operation of the pusher 130 thus constructed will be described. FIGS. 9A through 9D are cross-sectional views explanatory of operation of the pusher 130.

The top ring 1 transfers a semiconductor wafer W to a wafer unloading position located above the pusher 130. Then, the air cylinder 136 (see FIG. 5) is actuated to lift the pusher 130 so that the upper surfaces of the attraction pads 200 are brought into contact with the semiconductor wafer W held by the top ring 1. Before the upper surfaces of the attraction pads 200 are brought into contact with the semiconductor wafer W, the attraction pads 200 are in a state shown in FIG. 8. At the same time as the contact of the attraction pads 200, the valve V11 is opened so as to connect the fluid chambers 209 in the attraction pads 200 to the vacuum source 207. Accordingly, as shown in FIG. 9A, the elastic membranes 201 of the attraction pads 200 become depressed like suckers, so that the attraction pads 200 attract the semiconductor wafer W on the upper surfaces thereof.

At the same time as the attraction of the semiconductor wafer W to the attraction pads 200, a pressurized fluid (e.g., compressed air or a mixture of nitrogen and pure water) is ejected to the semiconductor wafer W through the communication holes 61 a and 62a (see FIG. 2) of the suction portions 61 and 62 of the top ring 1 to release the semiconductor wafer W from the top ring 1. When the pressurized fluid is ejected through the communication holes 61a and 62a to the semiconductor wafer W, a pressurized fluid may be supplied to all of or part of the pressure chambers 22-25 to swell the membrane (elastic pad) 4 so as to push the semiconductor wafer W. Thus, the semiconductor wafer W can completely be removed from the top ring 1 by the attraction of the semiconductor wafer W to the attraction pads 200, the ejection of the pressurized fluid from the top ring 1, and the pressurization of the membrane of the top ring 1. Thereafter, as shown in FIG. 9B, the push stage 133 is lowered so as to space the semiconductor wafer W from the top ring 1 while the semiconductor wafer W is attracted to the attraction pads 200.

Then, the valve V11 is closed, and the valve V12 is opened. Thus, as shown in FIG. 9C, a pressurized fluid such as a nitrogen gas is introduced from the compressed fluid supply source 208 into the attraction pads 200 so as to swell the attraction pads 200 like balloons. Accordingly, the semiconductor wafer W is raised from the upper members of the attraction pads 200 to release the attraction of the semiconductor wafer W to the attraction pads 200. In this state, the pusher 130 is lowered. On the way to lower the pusher 130, the semiconductor wafer W is transferred from the pusher 130 to the transfer stage of the linear transporter 105. As shown in FIG. 9D, when the pusher 130 is completely lowered, the semiconductor wafer W is completely delivered to the linear transporter 105.

As described above, according to the present embodiment, when a semiconductor wafer W is transferred from the top ring 1 to the pusher 130, the semiconductor wafer W is attracted to the attraction pads 200 of the pusher 130. Therefore, the semiconductor wafer W can reliably be removed from the top ring 1. Further, since the attraction pads 200 attract the semiconductor wafer W, it is possible to prevent the semiconductor wafer W from falling down toward the pusher 130 with force due to ejection of the pressurized fluid when the semiconductor wafer W is released from the top ring 1. Thus, the semiconductor wafer W is subjected to no impact.

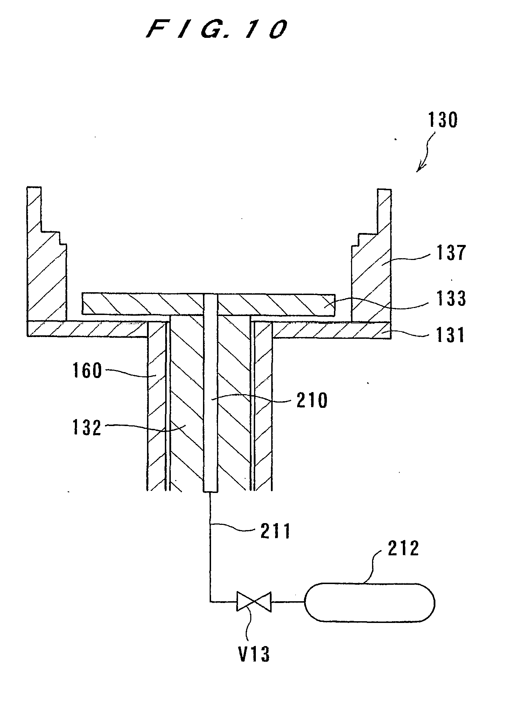

FIG. 10 shows a pusher 130 according to a second embodiment of the present invention. FIG. 10 is a cross-sectional view schematically showing the pusher 130 and illustrates only main part of the pusher 130. Thus, the pusher 130 is illustrated as including the guide stage 131, the top ring guides 137, the push stage 133, the spline shaft 132 to vertically move the push stage 133, and the hollow shaft 160. As shown in FIG. 10, the push stage 133 has a flat upper surface. The shaft 132, which vertically moves the push stage 133, and the push stage 133 have a fluid supply passage 210 connected through a pipe 211 to a pure water supply source 212. A valve V13 is provided on the pipe 211 connected to the pure water supply source 212.

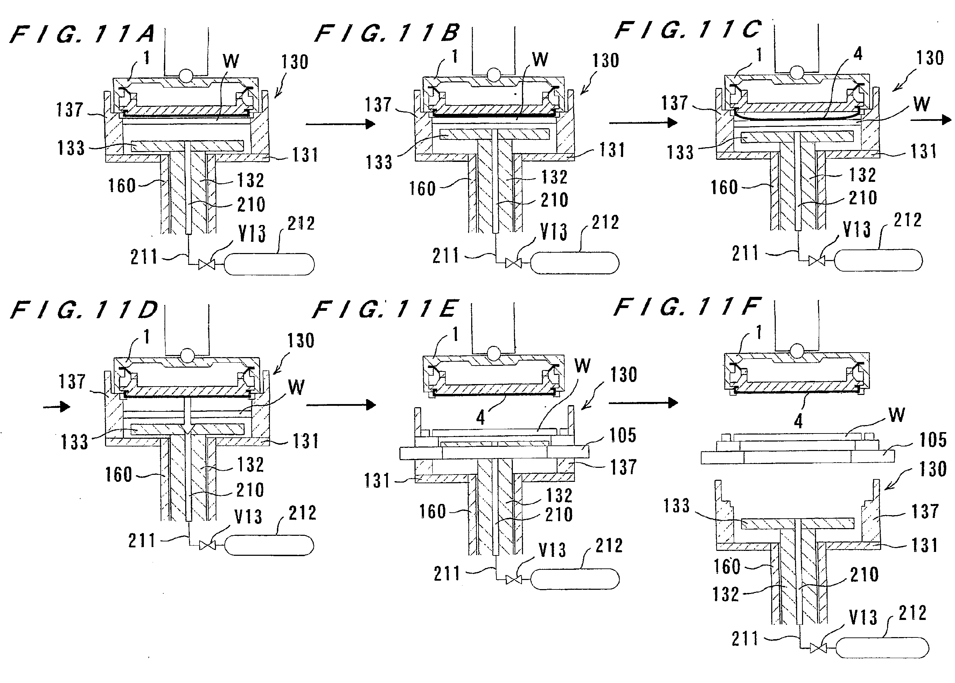

Operation of the pusher 130 thus constructed will be described. FIGS. 11A through 11F are cross-sectional views explanatory of operation of the pusher 130.

The top ring 1 transfers a semiconductor wafer W to a wafer unloading position located above the pusher 130. Then, the air cylinder 136 (see FIG. 5) is actuated to lift the pusher 130 so that the top ring 1 is brought into engagement with the top ring guides 137 as shown in FIG. 11A. At that time, the valve V13 is opened so as to supply pure water from the pure water supply source 212 through the fluid supply passage 210 to the upper surface of the push stage 133. Thus, a thin water film is formed on the upper surface of the push stage 133. In this state, as shown in FIG. 11B, the push stage 133 is lifted so as to bring the upper surface of the push stage 133 into contact with the semiconductor wafer W. At the time of the contact, the valve V13 is closed so as to stop the supply of the pure water to the upper surface of the push stage 133.

Since the thin water film is formed between the upper surface of the push stage 133 and the semiconductor wafer W, the semiconductor wafer W is attracted to the upper surface of the push stage 133 by surface tension of the water film. At the same time as the attraction of the semiconductor wafer W to the push stage 133 using the water film, a pressurized fluid (e.g., compressed air or a mixture of nitrogen and pure water) is ejected to the semiconductor wafer W through the communication holes 61a and 62a (see FIG. 2) of the suction portions 61 and 62 of the top ring 1 to release the semiconductor wafer W from the top ring 1, as shown in FIG. 11C. When the pressurized fluid is ejected through the communication holes 61a and 62a to the semiconductor wafer W, a pressurized fluid may be supplied to all of or part of the pressure chambers 22-25 to swell the membrane (elastic pad) 4 so as to push the semiconductor wafer W. Thus, the semiconductor wafer W can completely be removed from the top ring 1 by the attraction of the semiconductor wafer W to the push stage 133 using the water film, the ejection of the pressurized fluid from the top ring 1, and the pressurization of the membrane of the top ring 1.

Thereafter, as shown in FIG. 9D, the push stage 133 is lowered so as to space the semiconductor wafer W from the top ring 1 while the semiconductor wafer W is attracted by the push stage 133. Then, the valve V13 is opened so as to supply and flow pure water from the pure water supply source 212 to the upper surface of the push stage 133 to thereby release the attraction of the semiconductor wafer W by the water film. In this state, as shown in FIG. 11E, the pusher 130 is lowered. On the way to lower the pusher 130, the semiconductor wafer W is transferred from the pusher 130 to the transfer stage of the linear transporter 105. As shown in FIG. 11F, when the pusher 130 is completely lowered, the semiconductor wafer W is completely delivered to the linear transporter 105.

As described above, according to the present embodiment, when a semiconductor wafer W is transferred from the top ring 1 to the pusher 130, the semiconductor wafer W is attracted by the thin water film, which is formed on the upper surface of the push stage 133 of the pusher 130. Therefore, the semiconductor wafer W can reliably be removed from the top ring 1. Further, since the semiconductor wafer W is attracted by the thin water film, it is possible to prevent the semiconductor wafer W from falling down toward the pusher 130 with force due to ejection of the pressurized fluid when the semiconductor wafer W is released from the top ring 1. Thus, the semiconductor wafer W is subjected to no impact.

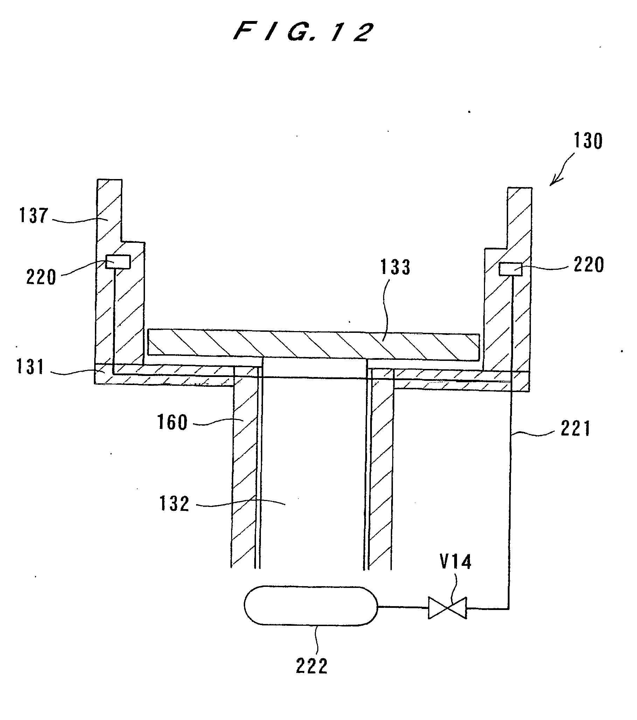

FIG. 12 shows a pusher 130 according to a third embodiment of the present invention. FIG. 12 is a cross-sectional view schematically showing the pusher 130 and illustrates only main part of the pusher 130. Thus, the pusher 130 is illustrated as including the guide stage 131, the top ring guides 137, the push stage 133, the spline shaft 132 to vertically move the push stage 133, and the hollow shaft 160. As shown in FIG. 12, the top ring guides 137 have one or more nozzles 220, which serve as high-pressure fluid ports for ejecting a high-pressure fluid toward the semiconductor wafer. The nozzles 220 are connected through a pipe 221 to a compressed fluid supply source 222. The nozzles 220 are located at positions at which a semiconductor wafer is removed from the top ring 1. A valve V14 is provided on the pipe 221 connected to the compressed fluid supply source 222. The compressed fluid supply source 222 is configured to supply high-pressure pure water or high-pressure mixture of two or more kinds of a liquid and a gas (e.g., pure water and nitrogen). The pusher 130 has a cover (not shown) for preventing an ejected high-pressure fluid from scattering around the nozzles 220.

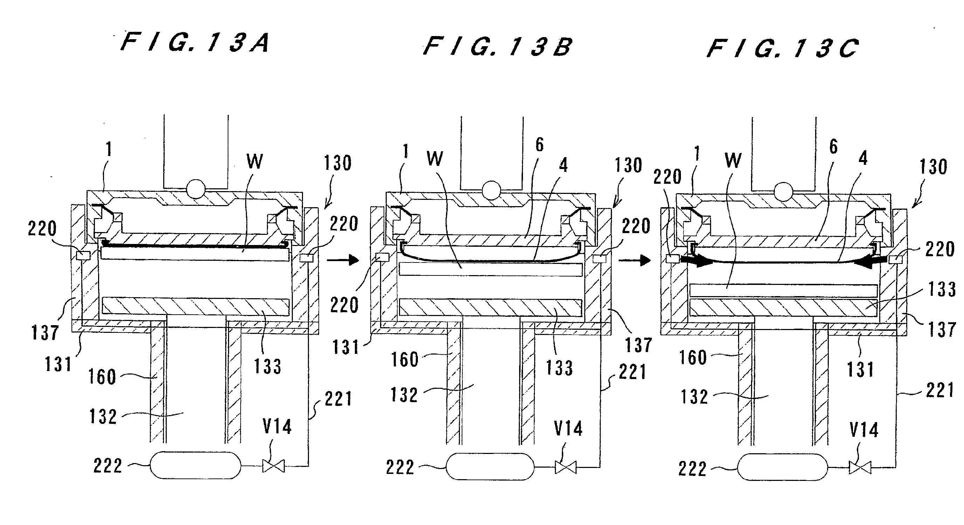

Operation of the pusher 130 thus constructed will be described. FIGS. 13A through 13C are cross-sectional views explanatory of operation of the pusher 130.

The top ring 1 transfers a semiconductor wafer W to a wafer unloading position located above the pusher 130. Then, the air cylinder 136 (see FIG. 5) is actuated to lift the pusher 130 so that the top ring 1 is brought into engagement with the top ring guides 137 as shown in FIG. 13A. Thereafter, as shown in FIG. 13B, a pressurized fluid (e.g., compressed air or a mixture of nitrogen and pure water) is ejected to the semiconductor wafer W through the communication holes 61a and 62a (see FIG. 2) of the suction portions 61 and 62 of the top ring 1, and another pressurized fluid is supplied to all of or part of the pressure chambers 22-25 to swell the membrane (elastic pad) 4. At that time, a pressurized fluid is supplied to the pressure chamber 21 so as to move the subcarrier plate 6 downward. Thus, the semiconductor wafer W is located below the lower end of the retainer ring 3, and the membrane 4 of the top ring 1 is separated and spaced from the semiconductor wafer W at a peripheral portion thereof. In such a state that the peripheral portion of the semiconductor wafer W is spaced from the membrane 4, the valve V14 is opened so as to eject a high-pressure fluid (e.g., pure water or mixture of gas such as nitrogen and pure water) from the nozzles 220. Thus, the semiconductor wafer W is removed from the membrane 4 by the high-pressure fluid (see FIG. 13C). Thereafter, the pusher 130 is lowered. On the way to lower the pusher 130, the semiconductor wafer W is transferred from the pusher 130 to the transfer stage of the linear transporter 105, which is not shown in the drawings.

As described above, according to the present embodiment, when a semiconductor wafer W is transferred from the top ring 1 to the pusher 130, a pressurized fluid is supplied to all of or part of the pressure chambers 22-25 to swell the membrane (elastic pad) 4. Another pressurized fluid is supplied to the pressure chamber 21 so as to move the subcarrier plate 6 downward. Thus, the semiconductor wafer W is located below the lower end of the retainer ring 3, and the membrane 4 of the top ring 1 is separated and spaced from the semiconductor wafer W at a peripheral portion thereof. In such a state, a high-pressure fluid is ejected from the nozzles 220 between the membrane 4 and the semiconductor wafer W. Thus, the semiconductor wafer W can be removed from the membrane 4 by pressure of the high-pressure fluid. When the semiconductor wafer W is removed from the top ring 1, only a slight gap is formed between the lower end surface of the semiconductor wafer W and the push stage 133. Accordingly, it is possible to prevent the semiconductor wafer from falling down toward the pusher 130 with force.

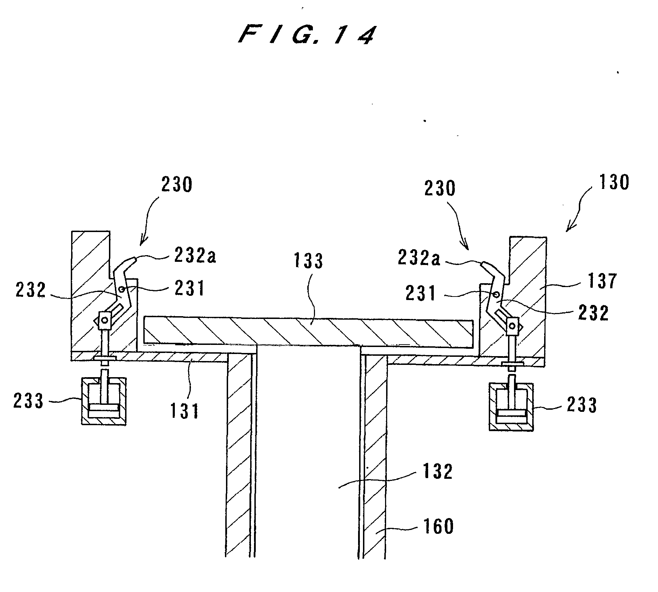

FIG. 14 shows a pusher 130 according to a fourth embodiment of the present invention. FIG. 14 is a cross-sectional view schematically showing the pusher 130 and illustrates only main part of the pusher 130. Thus, the pusher 130 is illustrated as including the guide stage 131, the top ring guides 137, the push stage 133, the spline shaft 132 to vertically move the push stage 133, and the hollow shaft 160. As shown in FIG. 14, the top ring guides 137 have one or more chucking mechanisms 230 for separating a semiconductor wafer from the top ring 1. The chucking mechanism 230 has a pivotable link 232 supported on the top ring guide 137 by a pin 231, and an air cylinder 233 connected to a lower end of the link 232. The link 232 has a sharpened tip 232a, which can readily be introduced between the membrane (elastic pad) 4 of the top ring 1 and the semiconductor wafer W.

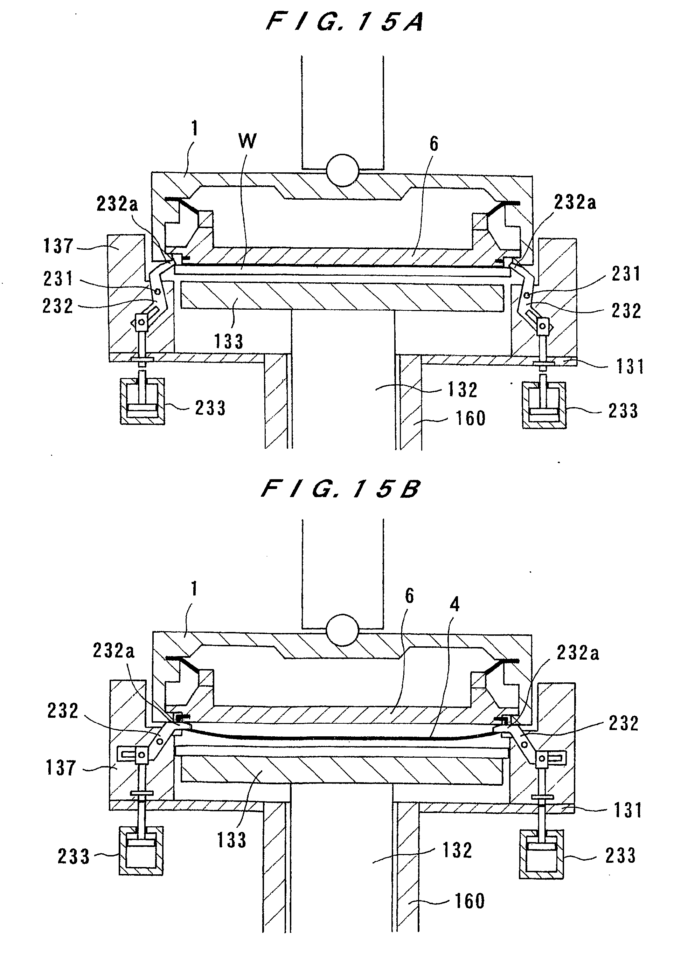

Operation of the pusher 130 thus constructed will be described. FIGS. 15A and 15B are cross-sectional views explanatory of operation of the pusher 130.

The top ring 1 transfers a semiconductor wafer W to a wafer unloading position located above the pusher 130. Then, the air cylinder 136 (see FIG. 5) is actuated to lift the pusher 130 so that the lower portion of the top ring 1 is introduced into the interior of the guide stages 137 as shown in FIG. 15A. Thereafter, a pressurized fluid (e.g., compressed air or a mixture of nitrogen and pure water) is ejected to the semiconductor wafer W through the communication holes 61 a and 62a (see FIG. 2) of the suction portions 61 and 62 of the top ring 1, and another pressurized fluid is supplied to all of or part of the pressure chambers 22-25 to swell the membrane (elastic pad) 4. At that time, a pressurized fluid is supplied to the pressure chamber 21 so as to move the subcarrier plate 6 downward. Thus, the semiconductor wafer W is located below the lower end of the retainer ring 3, and the membrane 4 of the top ring 1 is separated and spaced from the semiconductor wafer W at a peripheral portion thereof. In such a state, as shown in FIG. 15B, the air cylinders 233 are actuated to pivot the links 232 to introduce the tips 232a of the links 232 between the membrane 4 of the top ring 1 and the semiconductor wafer W. Thus, the semiconductor wafer W is forcibly separated from the membrane 4 by the links 232. Then, the push stage 133 is lowered so as to space the semiconductor wafer W from the top ring 1. Thereafter, the pusher 130 is lowered. On the way to lower the pusher 130, the semiconductor wafer W is transferred from the pusher 130 to the transfer stage of the linear transporter 105, which is not shown in the drawings.

As described above, according to the present embodiment, when a semiconductor wafer W is transferred from the top ring 1 to the pusher 130, a pressurized fluid is supplied to all of or part of the pressure chambers 22-25 to swell the membrane (elastic pad) 4. Another pressurized fluid is supplied to the pressure chamber 21 so as to move the subcarrier plate 6 downward. Thus, the semiconductor wafer W is located below the lower end of the retainer ring 3, and the membrane 4 of the top ring 1 is separated and spaced from the semiconductor wafer W at a peripheral portion thereof. In such a state, the air cylinders 233 are actuated to introduce the tips 232a of the links 232 between the membrane 4 of the top ring 1 and the semiconductor wafer W. Thus, the semiconductor wafer W is forcibly separated from the membrane 4 by the links 232. When the semiconductor wafer W is removed from the top ring 1, only a slight gap is formed between the lower end surface of the semiconductor wafer W and the push stage 133. Accordingly, it is possible to prevent the semiconductor wafer W from falling down toward the pusher 130 with force.

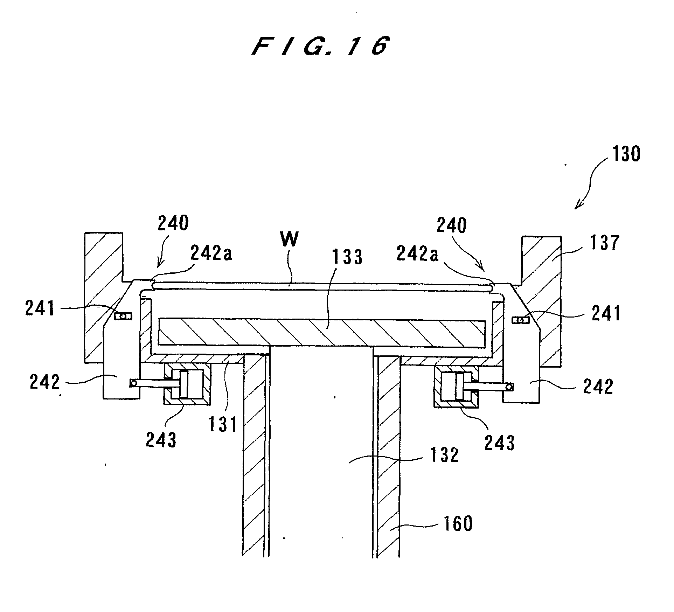

FIG. 16 is a cross-sectional view showing a variation of the pusher 130 according to the fourth embodiment of the present invention. As shown in FIG. 16, the top ring guides 137 have one or more chucking mechanisms 240 for separating a semiconductor wafer from the top ring 1. The chucking mechanism 240 has a link 242 supported on the top ring guide 137 and an air cylinder 243 connected to a lower end of the link 242. The link 242 is movable in a radial direction via a pin 231. The link 232 has a recessed tip 242a, which can hold a peripheral edge of a semiconductor wafer W.

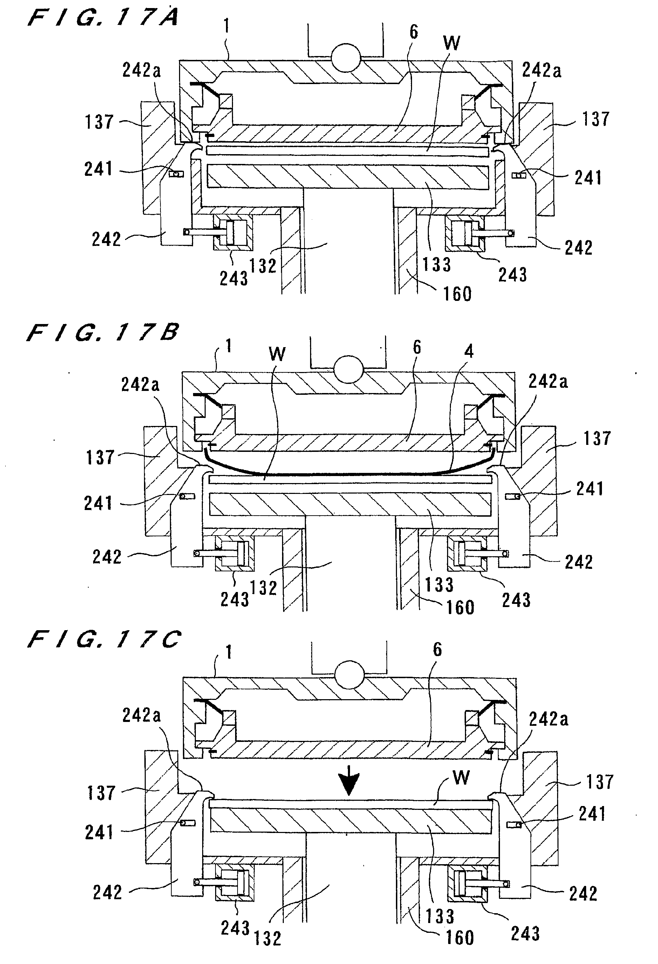

Operation of the pusher 130 thus constructed will be described below. FIGS. 17A through 17C are cross-sectional views explanatory of operation of the pusher 130.

The top ring 1 transfers a semiconductor wafer W to a wafer unloading position located above the pusher 130. Then, the air cylinder 136 (see FIG. 5) is actuated to lift the pusher 130 so that the lower portion of the top ring 1 is introduced into the interior of the guide stages 137 as shown in FIG. 17A. Thereafter, a pressurized fluid (e.g., compressed air or a mixture of nitrogen and pure water) is ejected to the semiconductor wafer W through the communication holes 61a and 62a (see FIG. 2) of the suction portions 61 and 62 of the top ring 1, and another pressurized fluid is supplied to all of or part of the pressure chambers 22-25 to swell the membrane (elastic pad) 4. At that time, a pressurized fluid is supplied to the pressure chamber 21 so as to move the subcarrier plate 6 downward. Thus, the semiconductor wafer W is located below the lower end of the retainer ring 3, and the membrane 4 of the top ring 1 is separated and spaced from the semiconductor wafer W at a peripheral portion thereof. In such a state, as shown in FIG. 17B, the air cylinders 243 are actuated to move the links 242 radially inward to hold the peripheral edge of the semiconductor wafer W horizontally by the recessed tips 242a of the links 242. Then, the pusher 130 is lowered as shown in FIG. 17C so as to space the semiconductor wafer W from the top ring 1 while the semiconductor wafer W is held by the links 242. On the way to lower the pusher 130, the semiconductor wafer W is transferred from the pusher 130 to the transfer stage of the linear transporter 105, which is not shown in the drawings.

As described above, according to the present embodiment, when a semiconductor wafer W is transferred from the top ring 1 to the pusher 130, a pressurized fluid is supplied to all of or part of the pressure chambers 22-25 to swell the membrane (elastic pad) 4. Another pressurized fluid is supplied to the pressure chamber 21 so as to move the subcarrier plate 6 downward. Thus, the semiconductor wafer W is located below the lower end of the retainer ring 3, and the membrane 4 of the top ring 1 is separated and spaced from the semiconductor wafer W at a peripheral portion thereof. In such a state, the air cylinders 243 are actuated to hold the peripheral edge of the semiconductor wafer W by the tips 242a of the links 242. Thus, the semiconductor wafer W is forcibly separated from the membrane 4 by the links 242. When the semiconductor wafer W is removed from the top ring 1, only a slight gap is formed between the lower end surface of the semiconductor wafer W and the push stage 133. Accordingly, it is possible to prevent the semiconductor wafer W from falling down toward the pusher 130 with force.

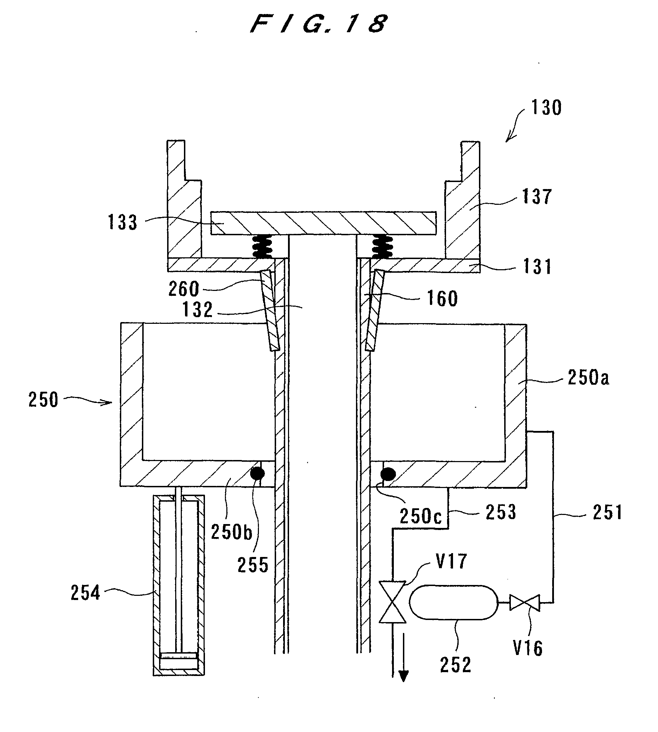

FIG. 18 shows a pusher 130 according to a fifth embodiment of the present invention. FIG. 14 is a cross-sectional view schematically showing the pusher 130 and illustrates only main part of the pusher 130. Thus, the pusher 130 is illustrated as including the guide stage 131, the top ring guides 137, the push stage 133, the spline shaft 132 to vertically move the push stage 133, and the hollow shaft 160. As shown in FIG. 18, a tub 250 is provided radially outward of the pusher 130. The tub 250 is in a form of a cylindrical receptacle and is disposed concentrically with the shaft 132 of the pusher 130. The tub 250 has a cylindrical portion 250a, which has an inside diameter larger than an outside diameter of the top ring guide 137, and a bottom portion 250b, which has an opening 250c. The tub 250 is connected through a pipe 251 to a pure water supply source 252. A valve V16 is provided on the pipe 251. A drain pipe 253 is connected to the bottom portion 250b of the tub 250. A valve V17 is provided on the drain pipe 253. An air cylinder 254 is connected to the bottom portion 250b of the tub 250. Thus, when the air cylinder 254 is actuated, the tub 250 is moved in a vertical direction.

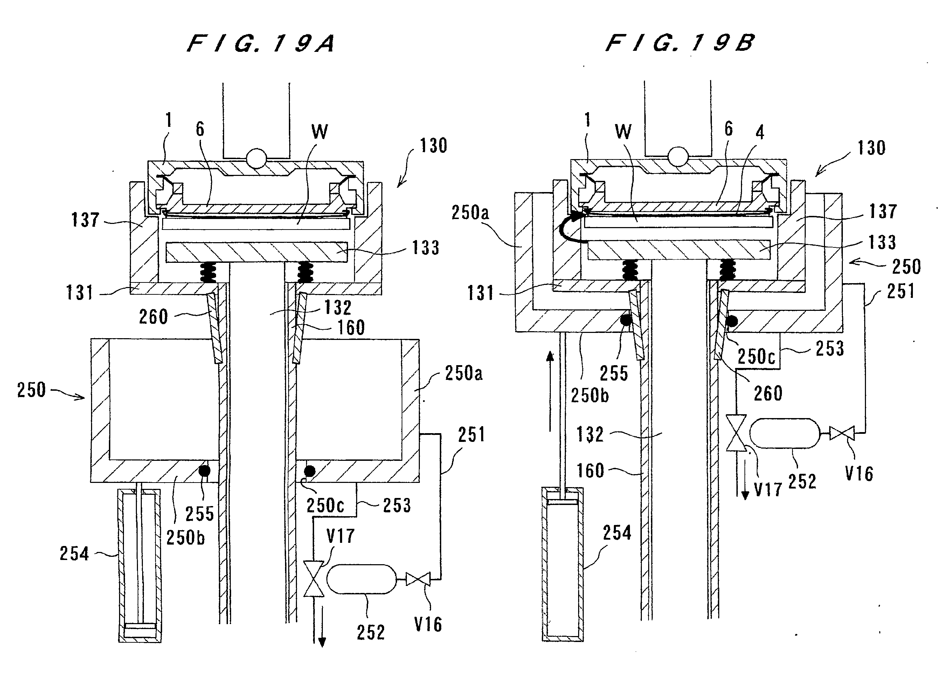

Operation of the pusher 130 thus constructed will be described below. FIGS. 19A and 19B are cross-sectional views explanatory of operation of the pusher 130.

The top ring 1 transfers a semiconductor wafer W to a wafer unloading position located above the pusher 130. Then, the air cylinder 136 (see FIG. 5) is actuated to lift the pusher 130 so that the top ring 1 is brought into engagement with the top ring guides 137 as shown in FIG. 19A. Then, the air cylinder 254 is actuated to lift the tub 250 so that the pusher 130 and the lower portion of the top ring 1 are housed in the tub 250. At that time, an O-ring 255 provided on the opening 250c of the tub 250 is brought into engagement with a cylindrical member 260, which projects downward from the pusher 130, to seal the interior of the tub 250. In this state, as shown in FIG. 19B, the valve V16 is opened so as to supply pure water from the pure water supply source 252 into the interior of the tub 250. Thus, the entire pusher 130 and the lower portion of the top ring 1 are immersed in the pure water in the tub 250.

At that time, a pressurized fluid (e.g., compressed air or a mixture of nitrogen and pure water) is ejected to the semiconductor wafer W through the communication holes 61a and 62a (see FIG. 2) of the suction portions 61 and 62 of the top ring 1, and another pressurized fluid is supplied to all of or part of the pressure chambers 22-25 to swell the membrane (elastic pad) 4. A pressurized fluid is supplied to the pressure chamber 21 so as to move the subcarrier plate 6 downward. Thus, the semiconductor wafer W is located below the lower end of the retainer ring 3, and the membrane 4 of the top ring 1 is separated and spaced from the semiconductor wafer W at a peripheral portion thereof. Thus, the pure water is introduced between the membrane (elastic pad) 4 of the top ring 1 and the semiconductor wafer W so as to release the adherence of the semiconductor wafer W to the top ring 1. Thus, the semiconductor wafer W is separated from the top ring 1. Then, the push stage 133 is lowered so as to space the semiconductor wafer W from the top ring 1. Thereafter, the pusher 130 is lowered. On the way to lower the pusher 130, the semiconductor wafer W is transferred from the pusher 130 to the transfer stage of the linear transporter 105, which is not shown in the drawings.

In the present embodiment, when a semiconductor wafer W is transferred from the top ring 1 to the pusher 130, the semiconductor wafer W is immersed in pure water. Accordingly, polishing wastes or slurry (polishing liquid) attached to the semiconductor wafer W can be removed by the pure water. Thus, the semiconductor wafer W can be cleaned simultaneously. Thereafter, the valve V17 of the drain pipe 253 is opened so as to discharge the pure water from the tub 250. After the pure water is discharged, the air cylinder 254 is actuated to lower the tub 250. Thus, operation of transferring the semiconductor wafer W is completed.

As described above, according to the present embodiment, pure water stored in the tub is introduced between the semiconductor wafer W and the substrate holding surface of the top ring 1 to release the adherence of the semiconductor wafer W to the top ring 1. Thus, the semiconductor wafer W can be separated from the top ring 1. Further, since water is present between the push stage 133 and the semiconductor wafer W when the semiconductor wafer W is separated from the top ring 1, it is possible to prevent the semiconductor wafer from falling down toward the pusher 130 with force due to ejection of the pressurized fluid.

Although certain preferred embodiments of the present invention have been shown and described in detail, it should be understood that various changes and modifications may be made therein without departing from the scope of the appended claims.

### Industrial Applicability

The present invention is suitable for use in a polishing apparatus for polishing a substrate such as a semiconductor wafer to a flat mirror finish.

## Claims

1. A polishing apparatus comprising:
a substrate holding device (1) configured to hold a substrate (W) on a substrate holding surface; and
a substrate relay device (130) configured to deliver the substrate (W) to said substrate holding device (1) and to receive the substrate (W) from said substrate holding device (1), said substrate relay device (130) including:
a substrate placement section (133) having a substrate placement surface on which the substrate is to be placed;
a moving mechanism (132) configured to vertically move said substrate placement section (133); and
a chucking mechanism (230, 240) which is adapted to be brought into contact with a peripheral portion of the substrate (W), **characterized in that**:
said chucking mechanism (230, 240) includes a tip member (232a, 242a) which is configured to be introduced between said substrate holding surface of said substrate holding device (1) and the peripheral portion of the substrate (W) held by said substrate holding device (1); and
said substrate relay device (130) is configured to be lowered while said tip member (232a, 242a) of said chucking mechanism (230, 240) is being brought into contact with the peripheral portion of the substrate (W) to separate the substrate (W) from said substrate holding device.

2. The polishing apparatus as recited in claim 1, wherein said chucking mechanism (230, 240) includes a link (242) configured to hold a peripheral edge of the substrate (W).

3. A polishing method for polishing a substrate (W), comprising:
holding the substrate by a substrate holding device (1),
delivering the substrate to said substrate holding device (1) or receiving the substrate from said substrate holding device (1) by a substrate relay device (130), wherein said substrate relay device (130) includes a substrate placement section (133) having a substrate placement surface on which the substrate is placed, a moving mechanism (132) configured to vertically move said substrate placement section (133), and a chucking mechanism (230, 240) which is brought into contact with a peripheral portion of the substrate (W), **characterized by**:
introducing a tip member (232a, 242a) of said chucking mechanism (230, 240) between said substrate holding surface of said substrate holding device (1) and the peripheral portion of the substrate (W) held by said substrate holding device (1);
lowering said substrate relay device (130) while said tip member (232a, 242a) of said chucking mechanism (230, 240) is being brought into contact with the peripheral portion of the substrate (W); and
separating the substrate (W) from said substrate holding device.

4. The polishing method as recited in claim 3, further comprises holding a peripheral edge portion of the substrate (W) by a link (242) of said chucking mechanism (230, 240).

## Patentansprüche

1. Eine Poliervorrichtung, die folgendes aufweist:
eine Substrathaltevorrichtung (1), die konfiguriert ist zum Halten eines Substrats W an einer Substrathaltefläche; und
eine Substratübergabevorrichtung (130), die konfiguriert ist zum Liefern des Substrats (W) an die die Substrathaltevorrichtung (1) und zum Empfangen des Substrats (W) von der Substrathaltevorrichtung (1), wobei die Substratübergabevorrichtung (130) folgendes aufweist:
einen Substratplatzierungsabschnitt (133) mit einer
Substratsplatzierungsoberfläche auf der das Substrat zu platzieren ist;
einen Bewegungsmechanismus (132), der konfiguriert ist zum vertikalen Bewegen des Substratplatzierungsabschnitts (133); und
einen Haltemechanismus (230, 240), der geeignet ist, in Kontakt mit einem Umfangsteil des Substrats (W) gebracht zu werden, **dadurch gekennzeichnet, dass**:
der Haltemechanismus (230, 240) ein Spitzenglied (232a, 242a) aufweist, dass konfiguriert ist, um zwischen die Substrathaltefläche der
Substrathaltevorrichtung (1) und den Umfangsteil des Substrats (W), dass durch die Substrathaltevorrichtung (1) gehalten wird, eingeführt zu werden; und
die Substratübergabevorrichtung (130) konfiguriert ist abgesenkt zu werden, während das Spitzenglied (232, 234) des Haltemechanismus (230, 240) in Kontakt mit dem Umfangsteil des Substrats (W) gebracht wurde, um das Substrat (W) von der Substrathaltevorrichtung zu trennen.

2. Poliervorrichtung nach Anspruch 1, wobei der Haltemechanismus (230, 240) eine Verbindung bzw. ein Verbindungsglied (242) aufweist, das konfiguriert ist zum Halten einer Umfangskante des Substrats (W).

3. Ein Polierverfahren zum Polieren eines Substrats (W), wobei das Verfahren folgendes aufweist:
Halten des Substrats durch eine Substrathaltevorrichtung (1),
Liefern des Substrats an die Substrathaltevorrichtung (1) oder Aufnehmen des Substrats von der Substrathaltevorrichtung (1) durch eine
Substratübergabevorrichtung (130), wobei die Substratübergabevorrichtung (130) einen Substratplatzierungsabschnitt (133) aufweist mit einer Substratplatzierungsfläche, auf die das Substrat platziert wird, einen Bewegungsmechanismus (132), der konfiguriert ist zum vertikalen Bewegen des Substratplatzierungsabschnitts (133) und einen Haltemechanismus (230, 240), der in Kontakt mit einem Umfangsteil des Substrats (W) gebracht wird, **gekennzeichnet durch**
Einführen eines Spitzengliedes (232a, 242a) des Haltemechanismus (230, 240) zwischen die Substrathaltefläche der Substrathaltevorrichtung (1) und den Umfangsteil des Substrats (W), das **durch** die Substrathaltevorrichtung (1) gehalten wird;
Absenken der Substratübergabevorrichtung (130) während das Spitzenglied (232a, 242a) des Haltemechanismus (230, 240) in Kontakt mit dem Umfangsteil des Substrats (W) gebracht ist; und
Separieren des Substrats (W) von der Substrathaltevorrichtung.

4. Polierverfahren nach Anspruch 3, das ferner das Halten eines Umfangkantenteils des Substrats (W) durch ein Verbindungselement (242) des Haltemechanismus (230, 240) aufweist.

## Revendications

1. Appareil de polissage comprenant :
un dispositif de maintien de substrat (1) agencé pour maintenir un substrat (W) sur une surface de maintien de substrat, et
un dispositif de relais de substrat (130) agencé pour fournir le substrat (W) au dispositif de maintien de substrat (1) et pour recevoir le substrat (W) à partir du dispositif de maintien de substrat (1), le dispositif de relais de substrat (130) comprenant :
une section de placement de substrat (133) comportant une surface de placement de substrat sur laquelle doit être placé le substrat ;
un mécanisme de déplacement (132) agencé pour déplacer verticalement la section de placement de substrat (133) ; et
un mécanisme de blocage (230, 240) adapté à être amené en contact avec une portion périphérique du substrat (W), **caractérisé en ce que** :
le mécanisme de blocage (230, 240) comprend un élément de pointe (232a, 242a) qui est agencé pour être introduit entre la surface de maintien de substrat du dispositif de maintien de substrat (1) et la portion périphérique du substrat (W) maintenue par le dispositif de maintien de substrat (1) ; et
le dispositif de relais de substrat (130) est agencé pour être descendu pendant que l'élément de pointe (232a, 242a) du mécanisme de blocage (230, 240) est amené en contact avec la portion périphérique du substrat (W) pour séparer le substrat (W) du dispositif de maintien de substrat.

2. Appareil de polissage selon la revendication 1, dans lequel le mécanisme de blocage (230, 240) comprend un bras de liaison (242) agencé pour maintenir un bord périphérique du substrat (W).

3. Procédé de polissage pour polir un substrat (W), comprenant :
maintenir le substrat par un dispositif de maintien de substrat (1),
fournir le substrat au dispositif de maintien de substrat (1) ou recevoir le substrat à partir du dispositif de maintien de substrat (1) par un dispositif de relais de substrat (130), le dispositif de relais de substrat (130) comprenant une section de placement de substrat (133) ayant une surface de placement de substrat sur laquelle est placé le substrat, un mécanisme de déplacement (132) agencé pour déplacer verticalement la section de placement de substrat (133), et un mécanisme de blocage (230, 240) qui est amené en contact avec une portion périphérique du substrat (W), **caractérisé par** les étapes suivantes :
introduire un élément de pointe (232a, 242a) du mécanisme de blocage (230, 240) entre la surface de maintien de substrat du dispositif de maintien de substrat (1) et la portion périphérique du substrat (W) maintenue par le dispositif de maintien de substrat (1) ;
descendre le dispositif de relais de substrat (130) pendant que l'élément de pointe (232a, 242a) du mécanisme de blocage (230, 240) est amené en contact avec la portion périphérique du substrat (W) ; et
séparer le substrat (W) du dispositif de maintien de substrat.

4. Procédé de polissage selon la revendication 3, comprenant en outre le fait de maintenir une portion de bord périphérique du substrat (W) par un bras de liaison (242) du mécanisme de blocage (230, 240).
